# EUROPEAN PATENT APPLICATION

(11) **EP 4 545 577 A1**
(43) Date of publication of application: **30.04.2025**
(21) Application number: 23831326.6
(22) Date of filing: 23.06.2023
(51) Int. Cl.: C08F 232/08, B32B 27/00, C08F 210/00, C08J 5/18, C08J 5/24, H05K 1/03

(54) **METHOD FOR PRODUCING VARNISH-LIKE CYCLIC OLEFIN COPOLYMER COMPOSITION, CYCLIC OLEFIN COPOLYMER COMPOSITION, CROSSLINKED PRODUCT, FILM, OR SHEET, LAMINATE, CIRCUIT BOARD, ELECTRONIC DEVICE, AND PREPREG**

(30) Priority: 27.06.2022 JP 2022102901
(71) Applicant: Mitsui Chemicals, Inc., Tokyo 104-0028 (JP)
(72) Inventor: UENO, Manami, Sodegaura-shi, Chiba 299-0265 (JP); NAKAI, Kazuoki, Sodegaura-shi, Chiba 299-0265 (JP); TAKEUCHI, Fumito, Sodegaura-shi, Chiba 299-0265 (JP); ASAHINA, Koutarou, Sodegaura-shi, Chiba 299-0265 (JP)
(74) Representative: Hoffmann Eitle
(86) International application number: PCT/JP2023/023419
(87) International publication number: WO 2024/004884

(57) **Abstract**

A method for producing a varnish-like cyclic olefin-based copolymer composition including a cyclic olefin-based copolymer (m) and an organic solvent, in which the cyclic olefin-based copolymer (m) includes (A) one or more repeating units derived from an olefin, (B) one or more repeating units derived from a cyclic non-conjugated diene, and (C) one or more repeating units derived from a cyclic olefin, the method includes a polymerization step of copolymerizing an olefin, a cyclic non-conjugated diene, and a cyclic olefin in a presence of a catalyst for olefin polymerization, containing a transition metal compound (A) and a compound (B), the transition metal compound (A) contains one or two or more selected from the group consisting of a transition metal compound (A-1) and a transition metal compound (A-2), and the compound (B) contains one or two or more selected from the group consisting of an organic metal compound (B-1), an organic aluminum oxy compound (B-2), and a compound (B-3) that reacts with the transition metal compound (A) to form an ion pair.

## Description

### TECHNICAL FIELD

The present invention relates to a method for producing a varnish-like cyclic olefin-based copolymer composition, a cyclic olefin-based copolymer composition, a crosslinked body, a film or sheet, a laminate, a circuit board, an electronic device, and a prepreg.

### BACKGROUND ART

In recent years, in addition to an increase in wireless communication devices and the like using high-frequency bands, an increase in the communication speed has inevitably led to high-frequency bands being widely used. Along with this, there is a demand for circuit boards having a small dielectric tangent to reduce transmission loss at high frequencies as much as possible.

Patent Documents 1 and 2 disclose that a sheet obtained by crosslinking cyclic olefin-based copolymers obtained by copolymerizing a specific diene compound with an organic peroxide and the like exhibits excellent dielectric characteristics.

In addition, Patent Document 3 or 4 discloses a crosslinkable resin molded body containing a crosslinkable cycloolefin polymer, in which the crosslinkable resin molded body is excellent in fluidity and solubility in a solvent during heating.

### RELATED DOCUMENT

### PATENT DOCUMENT

Patent Document 1: Japanese Unexamined Patent Publication No. 2010-100843
Patent Document 2: International Publication No. WO2012/046443
Patent Document 3: Japanese Unexamined Patent Publication No. 2019-081898
Patent Document 4: International Publication No. WO2021/149713

### NON-PATENT DOCUMENT

Non-Patent Document 1: Incoronata Tritto, Laura Boggioni, Cristina Zampa, and Dino R. Ferro, "Ethylene-Norbornene Copolymers by Cs-Symmetric Metallocenes: Determination of the Copolymerization Parameters and Mechanistic Considerations on the Basis of Tetrad Analysis" Macromolecules, 2005, 38, 9910-9919.

### SUMMARY OF THE INVENTION

### TECHNICAL PROBLEM

According to the studies conducted by the present inventors, it has been found that the cyclic olefin-based copolymer having a crosslinkable group as described in Patent Document 1 or 2 has room for further improvement in solubility in toluene in a state of including a large amount of the cyclic olefin-based copolymer (high solid content). It is considered that in a case where the solubility in toluene at a high solid content can be improved, it is possible to further improve the impregnability into a fiber base material during the manufacture of a circuit board.

In addition, it was found that the cyclic olefin-based copolymer having a crosslinkable group described in Patent Document 3 or 4 shows improvement in fluidity or solubility, but gelation is observed in a case where the cyclic olefin-based copolymer is dissolved in toluene in a state of including a large amount of the cyclic olefin-based copolymer (high solid content) and then allowed to stand at room temperature, and the fluidity is thus impaired.

In a case where the fluidity is impaired, a problem arises in that the stable impregnability into a fiber base material during a method for managing a varnish or the manufacture of a circuit board is impaired.

That is, according to the studies conducted by the present inventors, the inventions described in Patent Documents 3 and 4 had room for further improvement in terms of maintaining the solution state even in a varnish state where a large amount of the cyclic olefin-based copolymer having a crosslinkable group is included.

The present invention has been made in view of the circumstances, and provides a method for producing a varnish-like cyclic olefin-based copolymer composition that can maintain a solution state for a longer period of time even in a state where the varnish-like cyclic olefin-based copolymer composition includes a large amount of a cyclic olefin-based copolymer having a crosslinkable group (high solid content).

### SOLUTION TO PROBLEM

The present inventors have conducted intensive studies to achieve the object, and as a result, they have found that a varnish capable of maintaining a solution state for a longer period of time even in a state where a large amount of a cyclic olefin-based copolymer having a crosslinkable group is included (high solid content) can be prepared by improving a method for producing a cyclic olefin-based copolymer, thereby completing the present invention.

That is, according to the present invention, there are provided a method for producing a varnish-like cyclic olefin-based copolymer composition, a cyclic olefin-based copolymer composition, a crosslinked body, a film or sheet, a laminate, a circuit board, an electronic device, and a prepreg, which are described below.

1. A method for producing a varnish-like cyclic olefin-based copolymer composition including a cyclic olefin-based copolymer (m) and an organic solvent, in which the cyclic olefin-based copolymer (m) includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V), 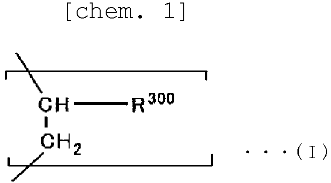 [in General Formula (I), R³⁰⁰ represents a hydrogen atom or a linear or branched hydrocarbon group having 1 to 29 carbon atoms] 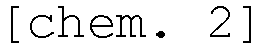 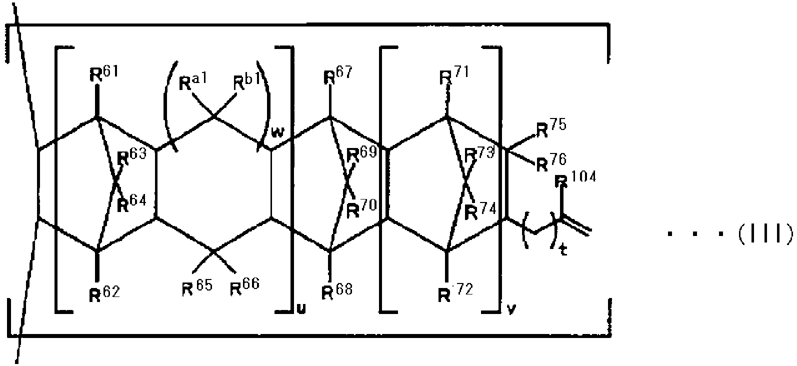 [in General Formula (III), u is 0 or 1, v is 0 or a positive integer, w is 0 or 1, R⁶¹ to R⁷⁶, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring] 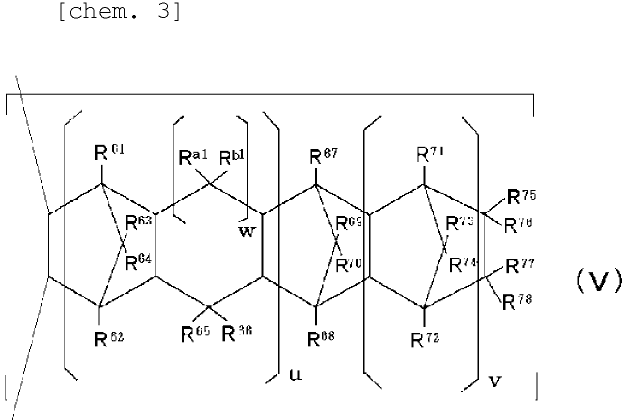
   [in General Formula (V), u is 0 or 1, v is 0 or a positive integer, w is 0 or 1, R⁶¹ to R⁷⁸, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring],
   the method includes a polymerization step of copolymerizing an olefin, a cyclic non-conjugated diene, and a cyclic olefin in a presence of a catalyst for olefin polymerization, containing a transition metal compound (A) and a compound (B), and the transition metal compound (A) contains one or two or more selected from the group consisting of a transition metal compound (A-1) represented by Formula (II) and a transition metal compound (A-2) represented by Formula (VI), 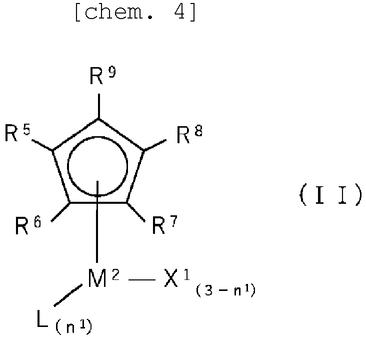
   [in Formula (II), M² represents a transition metal atom of Group 4 of a periodic table, n¹ represents an integer of 1 to 3, L's each independently represent a monovalent anionic ligand in which an atom of Group 15 of the periodic table serves as a coordinating atom, X¹'s each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, R⁵ to R⁹ each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, any two or three of R⁵ to R⁹ may be fused to form a ring, and the ring to be formed may have aromaticity including a conjugated double bond] 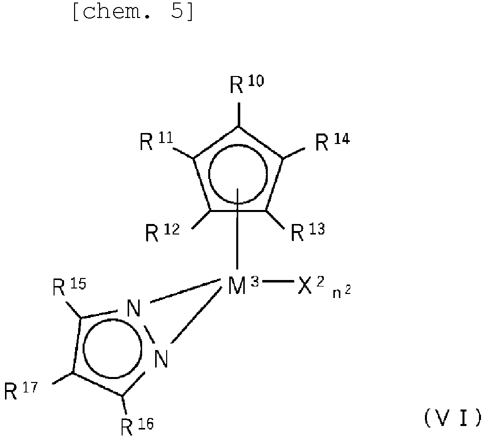
   [in Formula (VI), M³ represents a transition metal atom of Group 4 of the periodic table, n² represents an integer of 1 to **4,** X²'s each independently represent an atom or group selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, R¹⁰ to R¹⁷ each independently represent an atom or group selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, adjacent groups of R¹⁰ to R¹⁷ may be bonded to each other to form a ring, and the ring to be formed may have aromaticity including a conjugated double bond], and
   the compound (B) contains one or two or more selected from the group consisting of an organic metal compound (B-1), an organic aluminum oxy compound (B-2), and a compound (B-3) that reacts with the transition metal compound (A) to form an ion pair.
**2.** The production method according to 1.,
   in which a content of the cyclic olefin-based copolymer (m) in the varnish-like cyclic olefin-based copolymer composition is equal to or more than 30% by mass.
3. The production method according to 1. or 2.,
   in which the organic solvent includes at least one selected from the group consisting of an aromatic hydrocarbon-based solvent, a cyclic hydrocarbon-based solvent, a linear hydrocarbon-based solvent, and a halogenated aromatic hydrocarbon solvent.
4. The production method according to any one of 1. to 3.,
   in which in a case where a total number of moles of repeating units in the cyclic olefin-based copolymer (m) is set to 100% by mole, a content of the repeating units derived from the olefins (A) is equal to or more than 10% by mole and equal to or less than 90% by mole, a content of the repeating units derived from the cyclic non-conjugated dienes (B) is equal to or more than 1% by mole and equal to or less than 40% by mole, and a content of the repeating units derived from the cyclic olefins (C) is equal to or more than 1% by mole and equal to or less than 50% by mole.
5. The production method according to any one of 1. to 4.,
   in which the cyclic non-conjugated dienes constituting the repeating units derived from the cyclic non-conjugated dienes (B) include 5-vinyl-2-norbornene.
6. The production method according to any one of 1. to 5.,
   in which the cyclic olefins constituting the structural units derived from the cyclic olefins (C) include at least one selected from the group consisting of tetracyclo [4.4.0.1^{2,5}.1^{7,10}]-3-dodecene and bicyclo[2.2.1]-2-heptene.
7. The production method according to any one of 1. to 6.,
   in which the method further includes a catalyst removing step of removing the catalyst for olefin polymerization.
8. The production method according to any one of 1. to 7.,
   in which in a ¹³C-NMR spectrum of the cyclic olefin-based copolymer (m), in a case where an integral value of a signal in a range of equal to or more than 43.8 ppm and equal to or less than 45.0 ppm is defined as X_{C}, an integral value of a signal in a range of equal to or more than 40.3 ppm and equal to or less than 41.3 ppm is defined as Y_{A}, and an integral value of a signal in a range of equal to or more than 38.4 ppm and equal to or less than 39.9 ppm is defined as X_{B}, a value of (X_{B} - X_{C})/Y_{A} is equal to or more than 0.2 and equal to or less than 2.0.
9. The production method according to any one of 1. to 8.,
   in which a glass transition temperature of the cyclic olefin-based copolymer (m) measured by a differential scanning calorimeter (DSC) is equal to or higher than 100°C.
10. A cyclic olefin-based copolymer composition obtained by the production method according to any one of 1. to 9.
11. A crosslinked body obtained by crosslinking the cyclic olefin-based copolymer composition according to 10.
12. A film or sheet including:
   the crosslinked body according to 11.
13. A laminate obtained by laminating the film or sheet according to 12. over a base material.
14. A circuit board including:
   an electrically insulating layer including the crosslinked body according to 11.; and
   a conductor layer provided over the electrically insulating layer.
15. An electronic device including:
   the circuit board according to 14.
16. A prepreg including:
   the cyclic olefin-based copolymer composition according to 10.; and
   a sheet-like fiber base material.
17. A varnish-like cyclic olefin-based copolymer composition including:
   a cyclic olefin-based copolymer (m); and
   an organic solvent,
   in which the cyclic olefin-based copolymer (m) includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V), 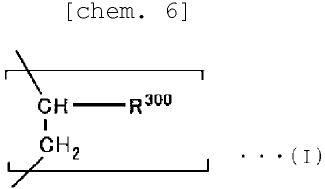
   [in General Formula (I), R³⁰⁰ represents a hydrogen atom or a linear or branched hydrocarbon group having 1 to 29 carbon atoms] 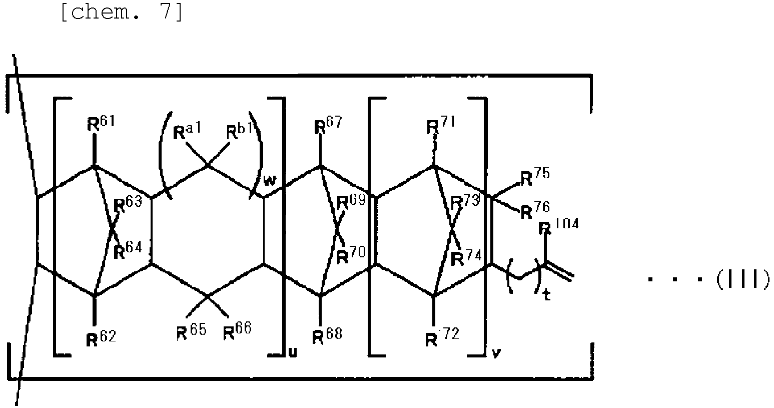
   [in General Formula (III), u is 0 or 1, v is 0 or a positive integer, w is 0 or 1, R⁶¹ to R⁷⁶, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring] 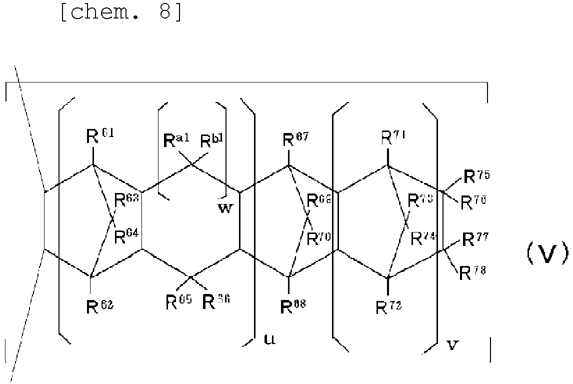
   [in General Formula (V), u is 0 or 1, v is 0 or a positive integer, w is 0 or 1, R⁶¹ to R⁷⁸, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring], and
   in a ¹³C-NMR spectrum of the cyclic olefin-based copolymer (m), in a case where an integral value of a signal in a range of equal to or more than 43.8 ppm and equal to or less than 45.0 ppm is defined as X_{C}, an integral value of a signal in a range of equal to or more than 40.3 ppm and equal to or less than 41.3 ppm is defined as Y_{A}, and a total of integral values of signals in a range of equal to or more than 38.4 ppm and equal to or less than 39.9 ppm is defined as X_{B}, a value of (X_{B} - X_{C})/Y_{A} is equal to or more than 0.2 and equal to or less than 2.0.
18. The varnish-like cyclic olefin-based copolymer composition according to 16.,
   in which a glass transition temperature of the cyclic olefin-based copolymer (m) measured by a differential scanning calorimeter (DSC) is equal to or higher than 100°C.
19. The varnish-like cyclic olefin-based copolymer composition according to 17. or 18.,
   in which a content of the cyclic olefin-based copolymer (m) in the varnish-like cyclic olefin-based copolymer composition is equal to or more than 30% by mass.
20. The varnish-like cyclic olefin-based copolymer composition according to any one of 17. to 19.,
   in which the organic solvent includes at least one selected from the group consisting of an aromatic hydrocarbon-based solvent, a cyclic hydrocarbon-based solvent, a linear hydrocarbon-based solvent, and a halogenated aromatic hydrocarbon solvent.
21. The varnish-like cyclic olefin-based copolymer composition according to any one of 17. to 20.,
   in which in a case where a total number of moles of repeating units in the cyclic olefin-based copolymer (m) is 100% by mole, a content of the repeating units derived from the olefins (A) is equal to or more than 10% by mole and equal to or less than 90% by mole, a content of the repeating units derived from the cyclic non-conjugated dienes (B) is equal to or more than 1% by mole and equal to or less than 40% by mole, and a content of the repeating units derived from the cyclic olefins (C) is equal to or more than 1% by mole and equal to or less than 50% by mole.
22. The varnish-like cyclic olefin-based copolymer composition according to any one of 17. to 21.,
   in which the cyclic non-conjugated dienes constituting the repeating units derived from the cyclic non-conjugated dienes (B) include 5-vinyl-2-norbornene.
23. The varnish-like cyclic olefin-based copolymer composition according to any one of 17. to 22.,
   in which the cyclic olefins constituting the structural units derived from the cyclic olefins (C) include at least one selected from the group consisting of tetracyclo [4.4.0.1^{2,5}.1^{7,10}]-3-dodecene and bicyclo[2.2.1]-2-heptene.
24. The varnish-like cyclic olefin-based copolymer composition according to any one of 17. to 23.,
   in which the olefins constituting the repeating units derived from the olefins (A) include ethylene, the cyclic non-conjugated dienes constituting the repeating units derived from the cyclic non-conjugated dienes (B) include 5-vinyl-2-norbornene, and the cyclic olefins constituting the structural units derived from the cyclic olefins (C) include tetracyclo[4.4.0.1^{2,5}.1^{7,10}] -3-dodecene.
25. A crosslinked body obtained by crosslinking the varnish-like cyclic olefin-based copolymer composition according to any one of 17. to 24.
26. A film or sheet including:
   the crosslinked body according to 25.
27. A laminate obtained by laminating the film or sheet according to 26. over a base material.
28. A circuit board including:
   an electrically insulating layer including the crosslinked body according to 25.; and
   a conductor layer provided over the electrically insulating layer.
29. An electronic device including:
   the circuit board according to 28.
30. A prepreg including:
   the varnish-like cyclic olefin-based copolymer composition according to any one of 17. to 24.; and
   a sheet-like fiber base material.

### ADVANTAGEOUS EFFECTS OF INVENTION

According to the present invention, it is possible to provide a method for producing a varnish-like cyclic olefin-based copolymer composition that can maintain a solution state for a longer period of time even in a state where the varnish-like cyclic olefin-based copolymer composition includes a large amount of a cyclic olefin-based copolymer having a crosslinkable group (high solid content).

### DESCRIPTION OF EMBODIMENTS

Hereinafter, the present invention will be described based on the embodiments. Furthermore, in the present embodiment, "A to B" indicating a numerical value range represents a range of equal to or more than A and equal to or less than B unless otherwise specified.

In a case where a numerical value range is described in a stepwise manner, the upper limit and the lower limit of each numerical value range can be optionally combined.

Each monomer constituting the cyclic olefin-based copolymer according to the present invention may be a monomer obtained from a fossil raw material, or may be a monomer obtained from an animal- or plant-based raw material.

### [Method for Producing Varnish-Like Cyclic Olefin-Based Copolymer Composition]

Hereinafter, a method for producing a varnish-like cyclic olefin-based copolymer composition will be described.

The method for producing a varnish-like cyclic olefin-based copolymer composition of the present embodiment is a method for producing a varnish-like cyclic olefin-based copolymer composition including a cyclic olefin-based copolymer (m) and an organic solvent, the method including a polymerization step of copolymerizing an olefin, a cyclic non-conjugated diene, and a cyclic olefin in a presence of a catalyst for olefin polymerization, containing a transition metal compound (A) and a compound (B).

By performing the polymerization in the presence of a catalyst for olefin polymerization, containing the transition metal compound (A) and the compound (B), it is possible to obtain a varnish-like cyclic olefin-based copolymer composition that can maintain a solution state for a longer period of time even in a state where the varnish-like cyclic olefin-based copolymer composition includes a large amount of a cyclic olefin-based copolymer having a crosslinkable group (high solid content).

<Catalyst for Olefin Polymerization>

The catalyst for olefin polymerization contains a transition metal compound (A) and a compound (B).

### <Transition Metal Compound (A)>

The transition metal compound (A) contains one or two or more selected from the group consisting of a transition metal compound (A-1) represented by Formula (II) and a transition metal compound (A-2) represented by Formula (VI).

The transition metal compound (A) preferably contains a transition metal compound (A-2) represented by Formula (VI).

### (Transition Metal Compound (A-1))

The transition metal compound (A-1) is represented by Formula (II).

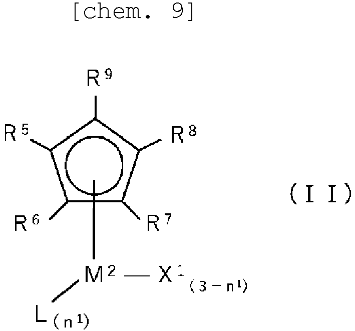

In Formula (II), M² represents a transition metal of Group 4 of the periodic table.

Examples of M² include a titanium atom, a zirconium atom, and a hafnium atom. M² is preferably the titanium atom or the zirconium atom, and more preferably the titanium atom.

n¹ represents an integer of 1 to 3. n¹ is selected such that the entire transition metal compound (A-1) represented by Formula (II) is electrically neutral, depending on the valence of M² and the type of X¹. n¹ is preferably 2.

L's each independently represent a monovalent anionic ligand in which an atom of Group 15 of the periodic table serves as a coordinating atom.

L is preferably a monovalent anionic ligand represented by Formula (IV).

[chem. 10]

-Y=Z-R¹⁸_{n³} (IV)

In Formula (IV), Y represents an atom of Group 15 of the periodic table. Examples of Y include a nitrogen atom, a phosphorus atom, and an arsenic atom. Y is preferably the nitrogen atom.

Z represents one kind of atom selected from Group 14, Group 15, or Group 16 of the periodic table. Examples of Z include a carbon atom, a silicon atom, and the like which belongs to Group 14; a nitrogen atom, a phosphorus atom, an arsenic atom, and the like, which belongs to Group 15; and an oxygen atom, a sulfur atom, and the like which belongs to Group 16.

Z is preferably the carbon atom or the nitrogen atom, and more preferably the carbon atom.

n³ represents an integer of 1 to 3. n³ is selected such that the entire monovalent anionic ligand represented by Formula (IV) is electrically neutral, depending on the valence of Z and the type of R¹⁸,

n² is preferably 1 or 2, and more preferably 2.

R¹⁸'s each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, these may be bonded to each other to form a ring, the ring to be formed may have aromaticity including a conjugated double bond, and the ring to be formed may be bonded to a cyclopentadienyl group.

Examples of the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R¹⁸, include those exemplified as the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R³ and R⁴.

Examples of the structure in which R¹⁸'s are bonded to each other to form a ring and the ring to be formed is bonded to a cyclopentadienyl group include the following structures.

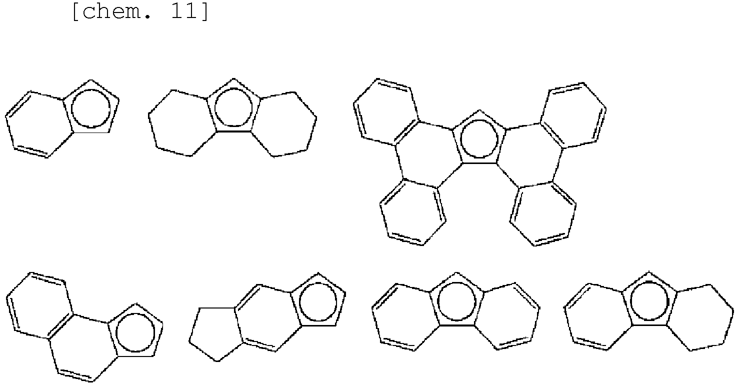

In a case where R¹⁸ is a group selected from the group consisting of the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the group consisting of the substitution products of these groups, the numbers of carbon atoms in R¹⁹'s are each independently preferably 1 to 20, and more preferably 1 to 10.

R¹⁸'s are each independently preferably an atom or group selected from the group consisting of the hydrogen atom, the alkyl group, the cycloalkyl group, the alkoxy group, the amide group, the aryl group, the aralkyl group, the silyl group, the alkylamide group, the alkylsilyl group, the arylamide group, the silylamide group, the phosphinoamide group, and the phosphide group, as well as the group consisting of s the substitution products of these groups, more preferably the alkyl group, the cycloalkyl group, or the aryl group, or the substitution product of the group, still more preferably a t-butyl group, a tricyclodecane group, or a phenyl group, or a substitution product of the group, and even still more preferably the t-butyl group.

X¹'s each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups.

Examples of the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by X¹, include those exemplified as the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R³ and R⁴.

In a case where X¹ is a group selected from the group consisting of the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the group consisting of the substitution products of these groups, the numbers of carbon atoms of X¹'s are each independently preferably 1 to 20, and more preferably 1 to 10.

X¹ is preferably the halogen atom, and more preferably the chlorine atom.

R⁵ to R⁹ each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, any two or three of R⁵ to R⁹ may be fused to form a ring, and the ring to be formed may have aromaticity including a conjugated double bond.

Examples of the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R⁵ to R⁹, include those exemplified as the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R³ and R⁴.

In a case where R⁵ to R⁹ are each a group selected from the group consisting of the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the group consisting of the substitution products of these groups, the numbers of carbon atoms in R⁵ to R⁹ are each independently preferably 1 to 20, and more preferably 1 to 10.

R⁵ to R⁹ are each preferably the hydrogen atom.

### (Transition Metal Compound (A-2))

The transition metal compound (A-2) is represented by Formula (VI).

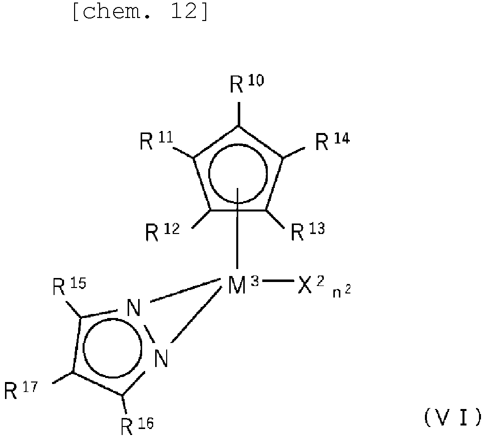

In Formula (VI), M³ represents a transition metal of Group 4 of the periodic table.

Examples of M³ include a titanium atom, a zirconium atom, and a hafnium atom.

M³ is preferably the titanium atom or the zirconium atom, and more preferably the titanium atom.

n² represents an integer of 1 to 4.

n² is selected such that the entire transition metal compound (A-2) represented by Formula (VI) is electrically neutral, depending on the valence of M³ and the type of X².

n² is preferably 2.

X²'s each independently represent an atom or group selected from the group consisting of a hydrogen atom, a halogen atom, a hydrocarbon group, a halogen-containing group, an oxygen-containing group, a sulfur-containing group, a nitrogen-containing group, a silicon-containing group, and a boron-containing group, as well as the group consisting of substitution products of these groups.

Examples of the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by X², include those exemplified as the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R³ and R⁴.

In a case where X² is a group selected from the group consisting of the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the group consisting of the substitution products of these groups, the numbers of carbon atoms of X²'s are each independently preferably 1 to 20, and more preferably 1 to 10.

X² is preferably the halogen atom, and more preferably the chlorine atom.

R¹⁰ to R¹⁷ each independently represent an atom or group selected from the group consisting of a hydrogen atom, a halogen atom, a hydrocarbon group, a halogen-containing group, an oxygen-containing group, a sulfur-containing group, a nitrogen-containing group, a silicon-containing group, and a boron-containing group, as well as the group consisting of substitution products of these groups, and adjacent ones among R¹⁰ to R¹⁴ may be bonded to each other to form a ring, and the ring to be formed may have aromaticity including a conjugated double bond.

Examples of the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products thereof, which are represented by R¹⁰ to R¹⁷, include those exemplified as the halogen atom, the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the substitution products of these groups, which are represented by R³ and R⁴.

In a case where R¹⁰ to R¹⁷ are each a group selected from the group consisting of the hydrocarbon group, the halogen-containing group, the oxygen-containing group, the sulfur-containing group, the nitrogen-containing group, the phosphorus-containing group, the silicon-containing group, the boron-containing group, and the aluminum-containing group, as well as the group consisting of the substitution products thereof, the numbers of carbon atoms in R¹⁰ to R¹⁷ are each independently preferably 1 to 20, and more preferably 1 to 10.

As a specific example of the combination of R¹⁰ to R¹⁷, it is preferable that R¹⁰ to R¹⁴ and R¹⁷ are each independently an atom or group selected from the group consisting of the hydrogen atom, the halogen atom, the hydrocarbon group, the halogen-containing group, and the silicon-containing group, as well as the group consisting of the substitution products of these groups, and R¹⁵ and R¹⁶ are each independently an atom or group selected from the group consisting of the hydrogen atom, the halogen atom, the hydrocarbon group, and the halogen-containing group, as well as the group consisting of the substitution products of these groups.

Adjacent groups among R¹⁰ to R¹⁴ may be bonded to each other to form a ring and the ring to be formed may be aromaticity including a conjugated double bond.

As a specific example of the combination of R¹⁰ to R¹⁷, it is more preferable that R¹⁰ to R¹⁴ and R¹⁷ are each independently the hydrogen atom or the hydrocarbon group, and R¹⁵ and R¹⁶ are each independently the hydrogen atom, the hydrocarbon group, or the halogen-containing hydrocarbon group.

As a specific example of the combination of R¹⁰ to R¹⁷, it is still more preferable that R¹⁰ to R¹⁴ and R¹⁷ are each independently the hydrogen atom, the alkyl group, or the cyclic hydrocarbon group to which two or more substituents are bonded, and R¹⁵ and R¹⁶ are each independently the hydrogen atom, the hydrocarbon group, or the halogen-containing alkyl group.

As a specific example of the combination of R¹⁰ to R¹⁷, it is even still more preferable that R¹⁰ to R¹⁴ and R¹⁷ are each independently the hydrogen atom or the t-butyl group, and R¹⁵ and R¹⁶ are each independently the hydrogen atom or the isopropyl group.

As a specific example of the combination of R¹⁰ to R¹⁷, it is preferable that R¹⁰ to R¹⁴ each independently represent the hydrogen atom, the branched alkyl group, or the cyclic hydrocarbon group to which two or more substituents are bonded, R¹⁵ and R¹⁶ each independently represent hydrogen, the cyclic hydrocarbon group, the branched alkyl group, or the halogen-containing alkyl group, and R¹⁷ represents the hydrogen atom, the branched alkyl group, or the halogen-containing alkyl group.

### <Compound (B)>

The compound (B) contains one or two or more selected from the group consisting of an organic metal compound (B-1), an organic aluminum oxy compound (B-2), and a compound (B-3) that reacts with the transition metal compound represented by Formula (II) or the transition metal compound represented by Formula (VI) to form an ion pair.

The compound (B) preferably contains one or two or more selected from the group consisting of the organic aluminum oxy compound (B-2) and the compound (B-3) that reacts with the transition metal compound (A) to form an ion pair, and more preferably contains both the organic aluminum oxy compound (B-2) and the compound (B-3) that reacts with the transition metal compound (A) to form an ion pair.

### (Organic Metal Compound (B-1))

Examples of the organic metal compound (B-1) (hereinafter also referred to as a "component (B-1)") include organic metal compounds of Groups 1, 2, 12, and 13, such as an organic aluminum compound (B-1a) represented by General Formula (B-1a), a complex alkyl compound (B-1b) of a metal of Group 1 and aluminum, represented by General Formula (B-1b), and a dialkyl compound (B-1c) of a metal of Group 2 or Group 12 represented by General Formula (B-1c).

### (B-1a): RaₘAl(ORb)ₙHₚX_{q}

In Formula (B-1a), Ra and Rb are each independently a hydrocarbon group having 1 to 15 carbon atoms, and preferably 1 to 4 carbon atoms, X is a halogen atom, m is a number satisfying 0 < m ≤ 3, n is a number satisfying 0 ≤ n < 3, p is a number satisfying 0 ≤ p < 3, and q is a number satisfying 0 ≤ q < 3 and m + n + p + q = 3. Examples of the organic aluminum compound (B-1a) include trialkylaluminum such as trimethylaluminum, triethylaluminum, and triisobutylaluminum, dialkylaluminum hydride such as diisobutylaluminum hydride, and tricycloalkylaluminum.

### (B-1b): M2AlRa₄

In Formula (B-1b), M2 is Li, Na, or K, and Ra is a hydrocarbon group having 1 to 15 carbon atoms, and preferably 1 to 4 carbon atoms. Examples of the complex alkyl compound (B-1b) include LiAl(C₂H₅)₄ and LiAl(C₇H₁₅)₄.

### (B-1c): RaRbM3

In Formula (B-1c), Ra and Rb are each independently a hydrocarbon group having 1 to 15 carbon atoms, and preferably 1 to 4 carbon atoms, and M3 is Mg, Zn, or Cd. Examples of the compound (B-1c) include dimethylmagnesium, diethylmagnesium, din-butylmagnesium, ethyl n-butylmagnesium, diphenylmagnesium, dimethylzinc, diethylzinc, di-n-butylzinc, and diphenylzinc.

Among the organic metal compounds (B-1), the organic aluminum compound (B-1a) is preferable.

### (Organic Aluminum Oxy Compound (B-2))

As the organic aluminum oxy compound (B-2) (hereinafter also referred to as a "component (B-2)"), an aluminoxane known in the related art can be used as it is.

Specific examples thereof include a compound represented by General Formula [B2-1] and/or General Formula [B2-2], the benzene-insoluble organic aluminum oxy compounds described in Japanese Unexamined Patent Publication No. H02-78687 and Japanese Unexamined Patent Publication No. H02-167305, and the aluminoxane having two or more kinds of alkyl groups described in Japanese Unexamined Patent Publication No. H03-103407.

In the formulae, R represents a hydrocarbon group having 1 to 10 carbon atoms, and n represents an integer of equal to or more than 2.

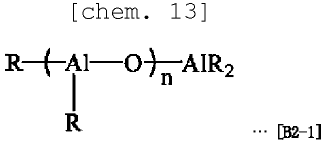

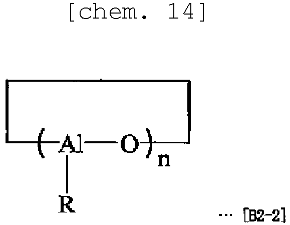

In addition, examples of the organic aluminum oxy compound (B-2) also include a modified methylaluminoxane represented by General Formula [B2-3].

In the formula, R represents a hydrocarbon group having 1 to 10 carbon atoms, and m and n each independently represent an integer of equal to or more than 2.

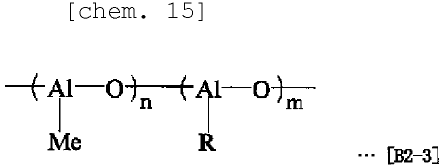

This modified methylaluminoxane is prepared using trimethylaluminum and an alkylaluminum other than trimethylaluminum. Such a compound is generally called an MMAO. Such an MMAO can be prepared by the methods described in United States Patent Nos. 4960878 and 5041584.

Furthermore, examples of the organic aluminum oxy compound (B-2) also include an organic aluminum oxy compound including boron, represented by General Formula [B2-4].

In the formula, R^{c} represents a hydrocarbon group having 1 to 10 carbon atoms. R^{d}'s may be the same as or different from each other and represent a hydrogen atom, a halogen atom, or a hydrocarbon group having 1 to 10 carbon atoms.

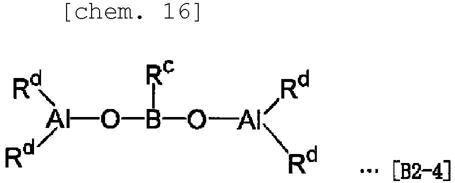

As the organic aluminum oxy compound (B-2), methylaluminoxane, which is easily available for a commercially available product, and an MMAO prepared using trimethylaluminum and triisobutylaluminum are preferable. Among these, the MMAO in which solubility in various solvents and storage stability are improved is more preferable.

### (Compound (B-3) That Reacts with Transition Metal Compound (A) to Form Ion Pair)

Examples of the compound (B-3) that reacts with the transition metal compound (A) to form an ion pair (hereinafter also referred to as an "ionic compound (B-3)" or a "component (B-3)") include the Lewis acids, the ionic compounds, the borane compounds, and the carborane compounds described in Japanese Unexamined Patent Publication Nos. H01-501950, H01-502036, H03-179005, H03-179006, H03-207703, and H03-207704, and United States Patent No. 5321106. Furthermore, examples thereof also include heteropoly compounds and isopoly compounds. It should be noted that the above-described organic aluminum oxy compound (B-2) is not included.

Preferred examples of the ionic compound (B-3) include a boron compound represented by General Formula [B3-1].

In the formula, examples of R^{e+} include H⁺, a carbenium cation, an oxonium cation, an ammonium cation, a phosphonium cation, a cycloheptatrienyl cation, and a ferrocenium cation having a transition metal. R^{f} to Rⁱ may be the same as or different from each other, and are each a substituent selected from a hydrocarbon group having 1 to 20 carbon atoms, a silicon-containing group, a nitrogen-containing group, an oxygen-containing group, a halogen atom, and a halogen-containing group, and preferably a substituted aryl group.

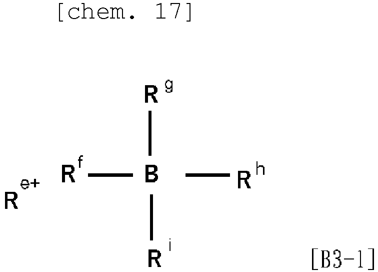

Examples of the boron compound represented by General Formula [B3-1] include triphenylcarbenium tetrakis(pentafluorophenyl)borate and the compounds described in [0133] to [0144] of International Publication No. WO2015/122414.

The method for producing a cyclic olefin-based copolymer of the present embodiment preferably includes a catalyst removing step of removing the catalyst for olefin polymerization. By including the catalyst removing step, the catalyst and the transition metal in the catalyst can be removed, whereby the electrical properties of the obtained cyclic olefin-based copolymer may be improved.

The polymerization reaction solution obtained in the polymerization step is mixed with an acidic aqueous solution such as a dilute aqueous hydrochloric acid solution, ion exchange water, or an alkali aqueous solution such as an aqueous sodium hydroxide solution, and then allowed to stand after the mixing until the liquid-liquid interface is separated, thereby extracting the cyclic olefin copolymer and the catalyst to the organic phase side and the water layer side, respectively, to separate the olefin copolymer and the catalyst.

It is preferable that the catalyst for olefin polymerization contains the transition metal compound (A-2) represented by Formula (VI), and the compound (B) contains one or two or more selected from the group consisting of the organic aluminum oxy compound (B-2) and the compound (B-3) that reacts with the transition metal compound (A) to form an ion pair.

### <Cyclic Olefin-Based Copolymer (m)>

The cyclic olefin-based copolymer (m) of the present embodiment includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V).

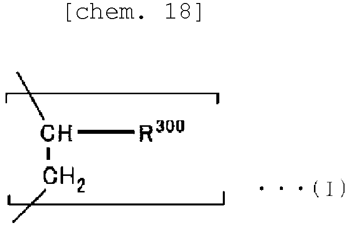

In General Formula (I), R³⁰⁰ represents a hydrogen atom or a linear or branched hydrocarbon group having 1 to 29 carbon atoms.

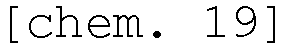

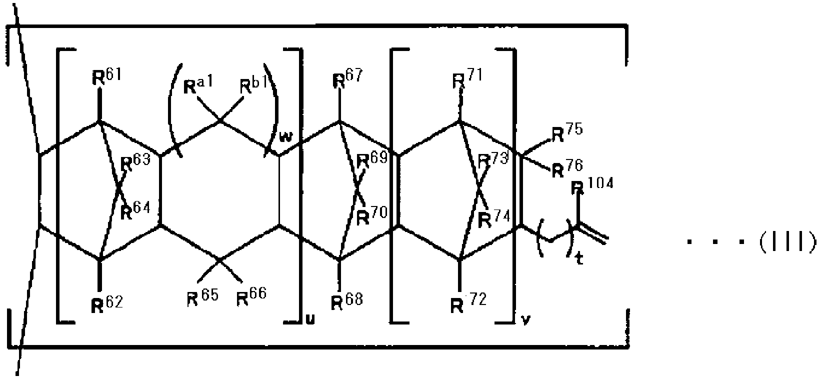

In General Formula (III), u is 0 or 1, v is 0 or a positive integer, preferably an integer of equal to or more than 0 and equal to or less than 2, and more preferably 0 or 1, w is 0 or 1, R⁶¹ to R⁷⁶ and R^{a1} and R^{b1} may be the same as or different from each other and are a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring.

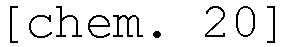

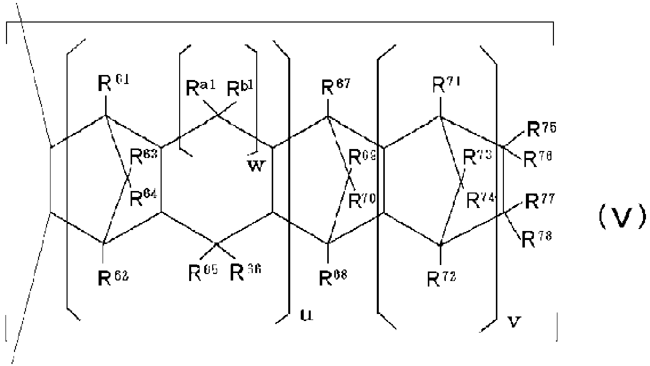

In General Formula (V), u is 0 or 1, v is 0 or a positive integer, preferably an integer of equal to or more than 0 and equal to or less than 2 and more preferably 0 or 1, w is 0 or 1, R⁶¹ to R⁷⁸, R^{a1}, and R^{b1} may be the same as or different from each other and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring.

In the cyclic olefin-based copolymer (m), in a case where the total number of moles of repeating units in the cyclic olefin-based copolymer (m) is set to 100% by mole, the content of the repeating units derived from the olefins (A) is preferably equal to or more than 10% by mole and equal to or less than 90% by mole, more preferably equal to or more than 15% by mole and equal to or less than 85% by mole, still more preferably equal to or more than 20% by mole and equal to or less than 80% by mole, even still more preferably equal to or more than 30% by mole and equal to or less than 80% by mole, even still further preferably equal to or more than 35% by mole and equal to or less than 70% by mole, and even still further preferably equal to or more than 40% by mole and equal to or less than 65% by mole, the content of the repeating units derived from the cyclic non-conjugated dienes (B) is preferably equal to or more than 1% by mole and equal to or less than 40% by mole, more preferably equal to or more than 2% by mole and equal to or less than 35% by mole, still more preferably equal to or more than 3% by mole and equal to or less than 25% by mole, and even still more preferably equal to or more than 5% by mole and equal to or less than 20% by mole, and the content of the repeating units derived from the cyclic olefins (C) is preferably equal to or more than 1% by mole and equal to or less than 50% by mole, more preferably equal to or more than 5% by mole and equal to or less than 48% by mole, still more preferably equal to or more than 10% by mole and equal to or less than 45% by mole, and even still more preferably equal to or more than 15% by mole and equal to or less than 43% by mole.

In a case where each of the contents of the repeating units in the cyclic olefin-based copolymer (m) is within the range, a crosslinked body obtained from the cyclic olefin-based copolymer composition is excellent in stability over time of the dielectric characteristics as well as heat resistance. Furthermore, it is possible to obtain a crosslinked body (Q) that is also excellent in mechanical characteristics, dielectric characteristics, transparency, and gas barrier properties. In other words, it is possible to obtain the crosslinked body (Q) that is excellent in a balance among these physical properties.

The olefin monomer, which is one of the copolymerization raw materials of the cyclic olefin-based copolymer (m), is a monomer providing the skeleton represented by Formula (I) by addition copolymerization, which is an olefin represented by General Formula (Ia).

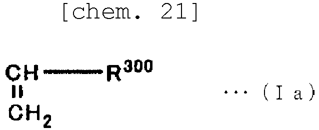

In General Formula (Ia), R³⁰⁰ represents a hydrogen atom or a linear or branched hydrocarbon group having 1 to 29 carbon atoms. Examples of the olefin represented by General Formula (Ia) include ethylene, propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene, and 1-eicosene. From the viewpoint of obtaining the crosslinked body (Q) that is excellent in heat resistance, mechanical characteristics, dielectric characteristics, transparency, and gas barrier properties, among those, ethylene and propylene are preferable, and ethylene is more preferable. Two or more of the olefin monomers represented by Formula (Ia) may be used.

The cyclic non-conjugated diene monomer, which is one of the copolymerization raw materials of the cyclic olefin-based copolymer (m), is subjected to addition copolymerization to form a constituent unit represented by Formula (III). Specifically, a cyclic non-conjugated diene represented by General Formula (IIIa), corresponding to General Formula (III), is used.

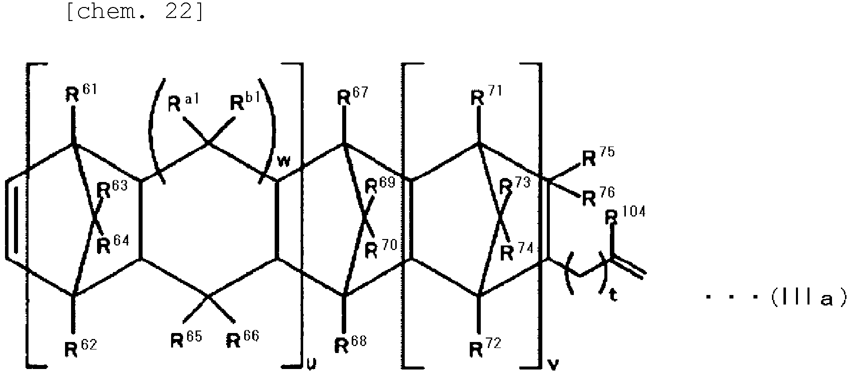

In General Formula (IIIa), u is 0 or 1, v is 0 or a positive integer, preferably an integer of equal to or more than 0 and equal to or less than 2, and more preferably 0 or 1, w is 0 or 1, R⁶¹ to R⁷⁶ and R^{a1} and R^{b1} may be the same as or different from each other and are a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring.

The cyclic non-conjugated diene represented by General Formula (IIIa) is not particularly limited and examples thereof include cyclic non-conjugated dienes represented by the following chemical formulae. Among these, 5-vinyl-2-norbornene or 8-vinyl-9-methyltetracyclo[4.4.0 .1^{2,5}.1^{7,10}]-3-dodecene is preferable, and 5-vinyl-2-norbornene is more preferable.

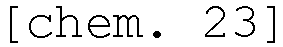

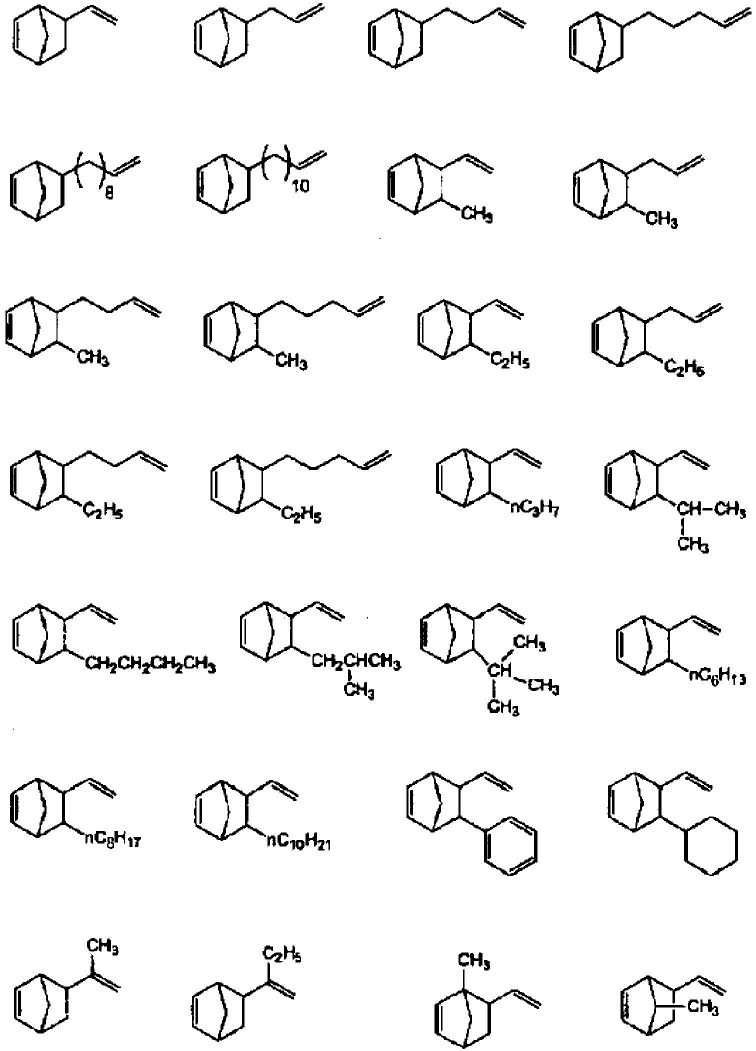

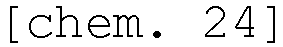

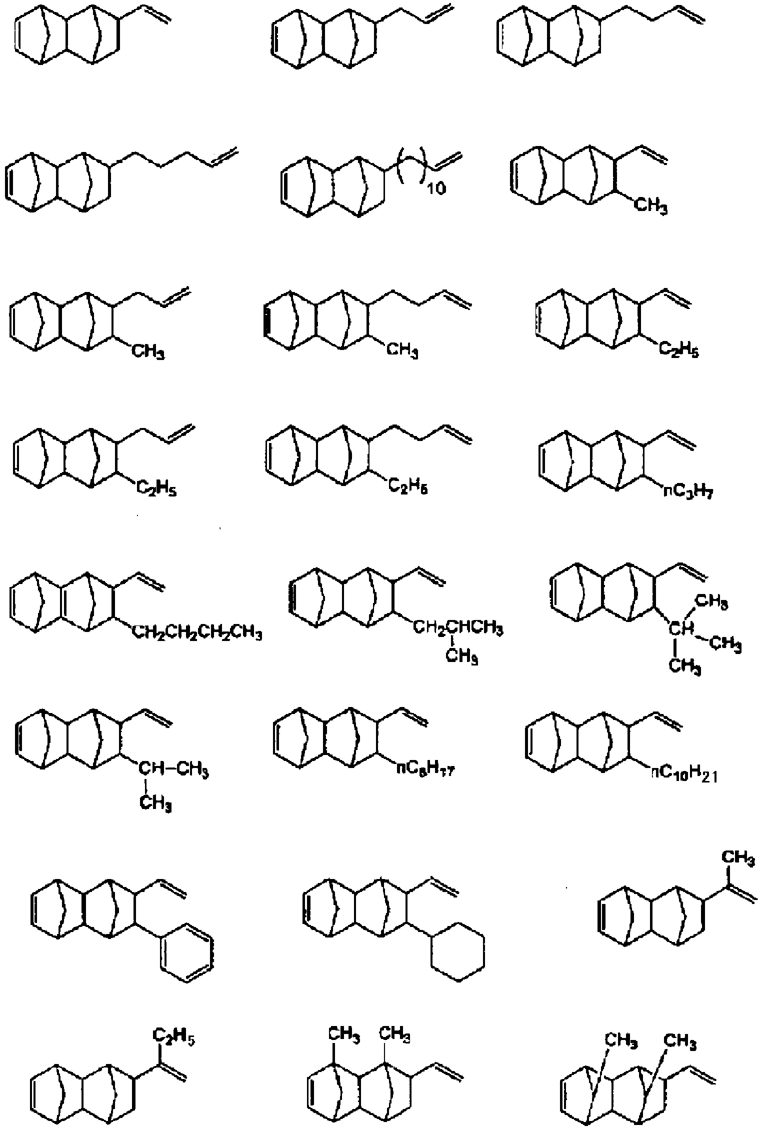

The cyclic non-conjugated diene represented by General Formula (IIIa) can also be specifically represented by General Formula (IIIb).

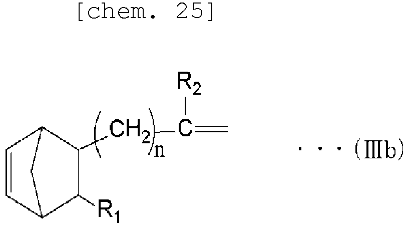

In General Formula (IIIb), n is an integer of 0 to 10, R₁ is a hydrogen atom or an alkyl group having 1 to 10 carbon atoms, and R₂ is a hydrogen atom or an alkyl group having 1 to 5 carbon atoms.

By configuring the cyclic olefin-based copolymer (m) of the present embodiment to include the constituent units derived from the cyclic non-conjugated dienes represented by General Formula (III), the cyclic olefin-based copolymer (m) has a double bond in a side chain portion, that is, a portion other than the main copolymerization chain.

The cyclic olefin monomer, which is one of the copolymerization raw materials of the cyclic olefin-based copolymer (m), is addition copolymerized to form the constituent unit represented by Formula (V). Specifically, a cyclic olefin monomer represented by General Formula (Va), corresponding to General Formula (V), is used.

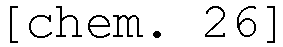

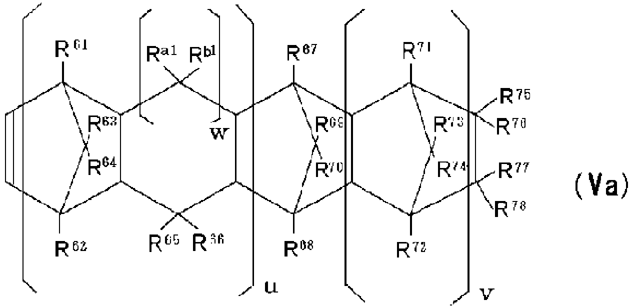

In General Formula (Va), u is 0 or 1, v is 0 or a positive integer, preferably an integer of equal to or more than 0 and equal to or less than 2 and more preferably 0 or 1, w is 0 or 1, R⁶¹ to R⁷⁸, R^{a1}, and R^{b1} may be the same as or different from each other and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring.

As a specific example of the cyclic olefin represented by General Formula (Va), the compounds described in International Publication No. WO2006/118261 can be used.

As the cyclic olefin represented by General Formula (Va), at least one selected from the group consisting of bicyclo[2.2.1]-2-heptene (also referred to as norbornene) and tetracyclo[4.4.0.1^{2,5}.1^{7,10}]-3-dodecene (also referred to as tetracyclododecene) is preferable, and tetracyclo [4.4.0.1^{2,5}.1^{7,10}]-3-dodecene is more preferable. Since these cyclic olefins have a rigid ring structure, the moduli of elasticity of the copolymer and the crosslinked body are easily retained, and since these cyclic olefins do not include a heterogeneous double bond structure, there is an advantage in that crosslinking is easily controlled.

By using, as the copolymerization component, the olefin monomer represented by General Formula (Ia) and the cyclic olefin represented by General Formula (Va) described above, the solubility of the cyclic olefin-based copolymer (m) in a solvent is further improved, and therefore, the moldability is good and the yield of the product is improved.

In the cyclic olefin-based copolymer (m), it is preferable that the olefins constituting the repeating units derived from the olefins (A) include ethylene, the cyclic non-conjugated dienes constituting the repeating units derived from the cyclic non-conjugated dienes (B) include 5-vinyl-2-norbornene, and the cyclic olefins constituting the structural units derived from the cyclic olefins (C) include tetracyclo [4.4.0.1^{2,5}.1^{7,10}]-3-dodecene. This further improves the stability of the cyclic olefin-based copolymer (m) in a case of being used as a varnish.

In addition to (A) the one or more repeating units derived from an olefin represented by General Formula (I), (B) the repeating units derived from cyclic non-conjugated dienes represented by General Formula (III), and (C) the one or more repeating units derived from a cyclic olefin represented by General Formula (V), the cyclic olefin-based copolymer (m) may be formed of the repeating units derived from a cyclic olefin other than the cyclic non-conjugated diene represented by General Formula (III) and the cyclic olefin represented by General Formula (V), and/or from a chain polyene.

In such a case, in addition to the olefin monomer represented by General Formula (Ia), the cyclic non-conjugated diene monomer represented by General Formula (IIIa), and the cyclic olefin monomer represented by General Formula (Va), a cyclic olefin monomer other than the cyclic non-conjugated diene monomer represented by General Formula (IIIa) and the cyclic olefin monomer represented by General Formula (Va), and/or a chain polyene monomer can be used as the copolymerization raw materials of the cyclic olefin-based copolymer (m).

A cyclic olefin represented by General Formula (VIa) or (VIIa), or a chain polyene represented by General Formula (VIIIa) is used as such the cyclic olefin monomer and the chain polyene monomer. Two or more different kinds of these cyclic olefins and chain polyenes may be used.

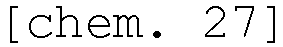

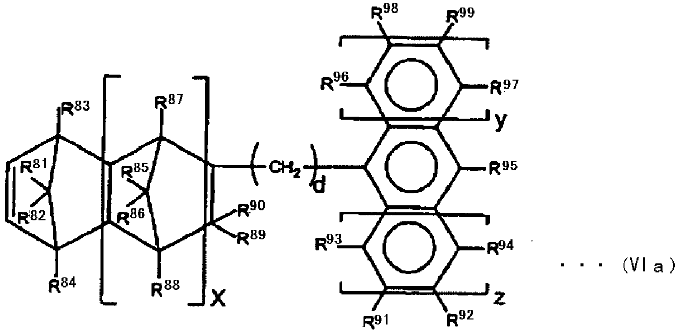

In General Formula (VIa), x and d are each 0 or an integer of equal to or more than 1, preferably an integer of equal to or more than 0 and equal to or less than 2, and more preferably 0 or 1, y and z are each 0, 1, or 2, R⁸¹ to R⁹⁹ may be the same as or different from each other and are each a hydrogen atom, a halogen atom, an aliphatic hydrocarbon group which is an alkyl group having 1 to 20 carbon atoms or a cycloalkyl group having 3 to 15 carbon atoms, an aromatic hydrocarbon group or alkoxy group having 6 to 20 carbon atoms, a carbon atom to which R⁸⁹ and R⁹⁰ are bonded may be bonded to a carbon atom to which R⁹³ is bonded or a carbon atom to which R⁹¹ is bonded directly or through an alkylene group having 1 to 3 carbon atoms, and in a case of y = z = 0, R⁹⁵ and R⁹², or R⁹⁵ and R⁹⁹ may be bonded to each other to form a monocyclic aromatic ring or a polycyclic aromatic ring.

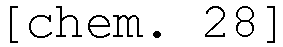

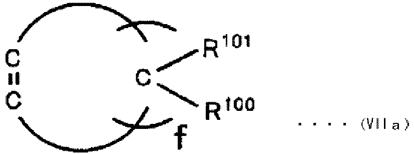

In General Formula (VIIa), R¹⁰⁰ and R¹⁰¹ may be the same as or different from each other, and each represent a hydrogen atom or a hydrocarbon group having 1 to 5 carbon atoms, and f satisfies 1 ≤ f ≤ 18.

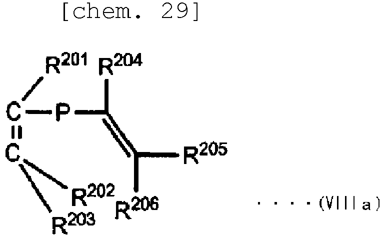

In General Formula (VIIIa), R²⁰¹ to R²⁰⁶ may be the same as or different from each other, and are each a hydrogen atom or a hydrocarbon group having 1 to 20 carbon atoms, and P is a linear or branched hydrocarbon group having 1 to 20 carbon atoms, which may include a double bond and/or a triple bond.

As specific examples of the cyclic olefins represented by General Formulae (VIa) and (VIIa), the compounds described in paragraphs 0037 to 0063 of International Publication No. WO2006/118261 can be used.

Specific examples of the chain polyene represented by General Formula (VIIIa) include 1,4-hexadiene, 3-methyl-1,4-hexadiene, 4-methyl-1,4-hexadiene, 5-methyl-1,4-hexadiene, 4,5-dimethyl-1,4-hexadiene, 7-methyl-1,6-octadiene, DMDT, 1,3-butadiene, and 1,5-hexadiene. In addition, a cyclizable polyene cyclized from a polyene such as 1,3-butadiene and 1,5-hexadiene may also be used.

In a case where the cyclic olefin-based copolymer (m) includes a constituent unit derived from a chain polyene represented by General Formula (VIIIa), or a constituent unit derived from a cyclic olefin other than the cyclic non-conjugated diene represented by General Formula (III) and the cyclic olefin represented by General Formula (V) (for example, General Formula (VIa) and General Formula (VIIa)), the content of the constituent unit is usually 0.1% to 100% by mole, and preferably 0.1% to 50% by mole with respect to the total number of moles of the one or more repeating units derived from an olefin represented by General Formula (I), the one or more repeating units derived from a cyclic non-conjugated diene represented by General Formula (III), and the one or more repeating units derived from a cyclic olefin represented by General Formula (V).

By using, as a copolymerization component, the olefin monomer represented by General Formula (I), the cyclic olefin represented by General Formula (VIa) or (VIIa), and the chain polyene represented by General Formula (VIIIa) described above, the solubility of the cyclic olefin-based copolymer (m) in a solvent is further improved, whereby the moldability is improved and the yield of the product is improved. Among these, the cyclic olefin represented by General Formula (VIa) or (VIIa) is preferable. Since these cyclic olefins have a rigid ring structure, the moduli of elasticity of the copolymer and the crosslinked body are easily retained, and since these cyclic olefins do not include a heterogeneous double bond structure, there is an advantage in that crosslinking is easily controlled.

According to the charge ratio of the monomer depending on a desired use, the content of the comonomer and the glass transition point (Tg) of the cyclic olefin-based copolymer (m) can be controlled.

The Tg of the cyclic olefin-based copolymer (m) is preferably equal to or lower than 300°C, more preferably equal to or lower than 250°C, still more preferably equal to or lower than 200°C, even still more preferably equal to or lower than 170°C, and even still further preferably equal to or lower than 150°C. In a case where the Tg is equal to or lower than the upper limit value, the melt moldability of the cyclic olefin-based copolymer (m) and the solubility in a solvent during varnishing are improved.

From the viewpoint of improving the heat resistance, the Tg of the cyclic olefin-based copolymer (m) is preferably equal to or higher than 100°C, more preferably equal to or higher than 110°C, still more preferably equal to or higher than 120°C, even still more preferably equal to or higher than 125°C, and even still further preferably equal to or higher than 130°C.

From the viewpoint of improving a balance among the melt moldability, the solubility in a solvent, and the heat resistance, the Tg of the cyclic olefin-based copolymer (m) is preferably equal to or higher than 100°C and equal to or lower than 300°C, more preferably equal to or higher than 110°C and equal to or lower than 250°C, still more preferably equal to or higher than 120°C and equal to or lower than 200°C, even still more preferably equal to or higher than 125°C and equal to or lower than 170°C, and even still further preferably equal to or higher than 130°C and equal to or lower than 150°C.

The intrinsic viscosity [η] of the cyclic olefin-based copolymer (m) measured in decahydronaphthalene at 135°C is, for example, in a range of 0.05 to 5 dl/g, preferably 0.07 to 1 dl/g, and more preferably 0.08 to 0.5 dl/g. In a case where the intrinsic viscosity [η] is equal to or less than the upper limit value, the moldability is improved. In addition, in a case where the intrinsic viscosity [η] is equal to or more than the lower limit value, the heat resistance and the mechanical characteristics of the crosslinked body (Q) obtained by crosslinking the cyclic olefin-based copolymer composition are improved.

It is possible to control the intrinsic viscosity [η] of the cyclic olefin-based copolymer (m) using polymerization conditions such as a polymerization catalyst, a co-catalyst, an amount of H₂ to be added, and a polymerization temperature.

The number-average molecular weight (Mn) of the cyclic olefin-based copolymer (m) determined by GPC measurement is preferably equal to or more than 1,000, more preferably equal to or more than 2,000, still more preferably equal to or more than 5,000, and even still more preferably equal to or more than 7,000, is preferably equal to or less than 100,000, more preferably equal to or less than 70,000, still more preferably equal to or less than 50,000, and even still more preferably equal to or less than 25,000, and is preferably equal to or more than 1,000 and equal to or less than 100,000, more preferably equal to or higher than 2,000 and equal to or less than 70,000, still more preferably equal to or higher than 5,000 and equal to or less than 50,000, and even still more preferably equal to or more than 7,000 and equal to or less than 25,000. This further improves the stability of the cyclic olefin-based copolymer (m) in a case of being used as a varnish. That is, in a case where the varnish is adjusted and stored, the occurrence of precipitates and the gelation are further suppressed.

### <Polymer physical properties>

The cyclic olefin-based copolymer (m) according to the present embodiment is considered to have specific stereoregularity. Specifically, it is considered that the cyclic olefin-based copolymer (m) has a ratio between the meso structure and the racemic structure in a chain structure of the repeating unit (C)-the repeating unit (A)-the repeating unit (C) in a certain range. This further improves the stability of the cyclic olefin-based copolymer (m) in a case of being used as a varnish.

The stereoregularity of the cyclic olefin-based copolymer (m) according to the present embodiment is measured by ¹³C-NMR. Hereinafter, a signal position of ¹³C-NMR, a method of measuring the signal, and the like will be described.

First, the specific stereoregularity according to the present embodiment will be described by taking a polymer having a structure represented by the following general formula as an example.

The meso structure in the chain of the repeating unit (C)-the repeating unit (A)-the repeating unit (C) means a structure described as αβm in FIG. 5 of Non-Patent Document 1. In addition, the racemic structure refers to a structure described as αβr in the drawing. 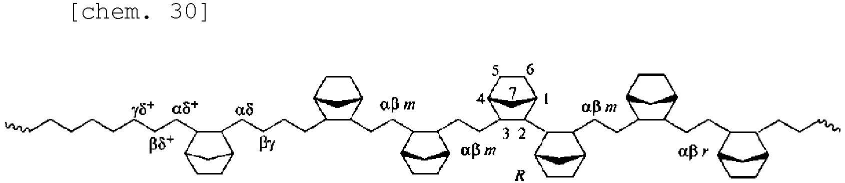 (Cited from p. 9,913, FIG. 5 of Non-Patent Document 1)

FIG. 5 of Non-Patent Document 1 is an example and shows a structure in which norbornene and ethylene are linked in a chain. A structure in which the spatial orientations of the chiral carbons of norbornene, adjacent to each other with ethylene therebetween are the same is called a meso structure, whereas a structure in which the orientations are different is called a racemic structure. In FIG. 5 of Non-Patent Document 1, norbornene is described as an example of the cyclic olefins that forms the repeating unit (C), but the same applies to a case where the cyclic olefin that forms the repeating unit (C) is tetracyclo [4.4.0.1^{2,5}.1^{7,10}]-3-dodecene. In addition, the same applies to a case where the cyclic olefin that forms the repeating unit (C) is a monomer other than these.

In the cyclic olefin copolymer (m) according to the present embodiment, it is preferable that a value of (X_{B} - X_{C})/Y_{A}, as calculated by the following calculation expression, is equal to or more than 0.2 and equal to or less than 2.0. Here, it is considered that the value of (X_{B} - X_{C})/Y_{A} corresponds to a ratio of the meso structure to the racemic structure in the chain structure of the repeating unit (C)-the repeating unit (A)-the repeating unit (C).

The lower limit of (X_{B} - X_{C})/Y_{A} is not particularly limited, but is preferably equal to or more than 0.2, more preferably equal to or more than 0.3, still more preferably equal to or more than 0.4, even still more preferably equal to or more than 0.5, even still further preferably equal to or more than 0.6, even still further preferably equal to or more than 0.7, and even still further preferably equal to or more than 0.8.

The upper limit of (X_{B} - X_{C})/Y_{A} is not particularly limited, but is preferably equal to or less than 2.0, more preferably equal to or less than 1.8, still more preferably equal to or less than 1.6, even still more preferably equal to or less than 1.5, even still further preferably equal to or less than 1.3, even still further preferably equal to or less than 1.1, and even still further preferably equal to or less than 1.0.

The numerical value range of (X_{B} - X_{C})/Y_{A} is not particularly limited, but can be set to, for example, equal to or more than 0.2 and equal to or less than 2.0, equal to or more than 0.3 and equal to or less than 1.8, equal to or more than 0.4 and equal to or less than 1.6, equal to or more than 0.5 and equal to or less than 1.5, equal to or more than 0.6 and equal to or less than 1.3, equal to or more than 0.7 and equal to or less than 1.1, or equal to or more than 0.8 and equal to or less than 1.0.

By setting the value of (X_{B} - X_{C})/Y_{A} within the range, the stability of the cyclic olefin-based copolymer (m) in a case of being used as a varnish is improved. The stereoregularity is appropriately adjusted by selecting a polymerization method, a catalyst to be used, a composition, or the like.

The value of (X_{B} - X_{C})/Y_{A} is determined as follows.

In the ¹³C-NMR spectrum of the cyclic olefin-based copolymer according to the present embodiment, in a case where an integral value of a signal in a range of 43.8 to 45.0 ppm is defined as X_{C}, an integral value of a signal in a range of 40.3 to 41.3 ppm is defined as Y_{A}, and a total of integral values of signals in a range of 38.4 to 39.9 ppm is defined as X_{B}, a value of (X_{B} - X_{C})/Y_{A} is obtained.

Here, X_{C} is an integral value of a signal derived from the repeating unit (B), Y_{A} is an integral value of a signal derived from the repeating unit (C), and X_{B} is a total of integral values of signals derived from the repeating unit (B) and an integral value of a signal derived from the repeating unit (C).

In principle, the ¹³C-NMR spectrum is measured under the measurement conditions described in Examples.

### <Varnish-Like Cyclic Olefin-Based Copolymer Composition>

Hereinafter, a varnish-like cyclic olefin-based copolymer composition will be described.

The varnish-like cyclic olefin-based copolymer composition of the present embodiment is a varnish-like cyclic olefin-based copolymer composition including a cyclic olefin-based copolymer (m) and an organic solvent, in which the cyclic olefin-based copolymer (m) includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V), 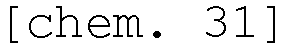 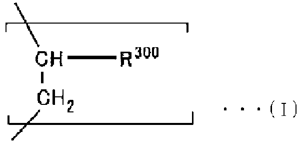 [in General Formula (I), R³⁰⁰ represents a hydrogen atom or a linear or branched hydrocarbon group having 1 to 29 carbon atoms] 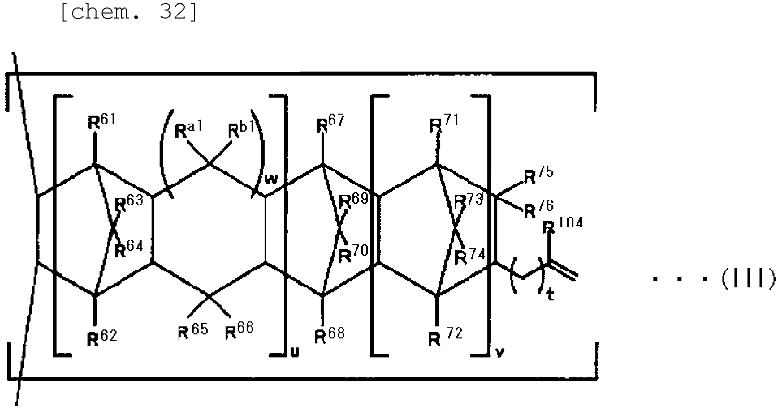 [in General Formula (III), u is 0 or 1, v is 0 or a positive integer, w is 0 or 1, R⁶¹ to R⁷⁶, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring] 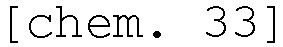 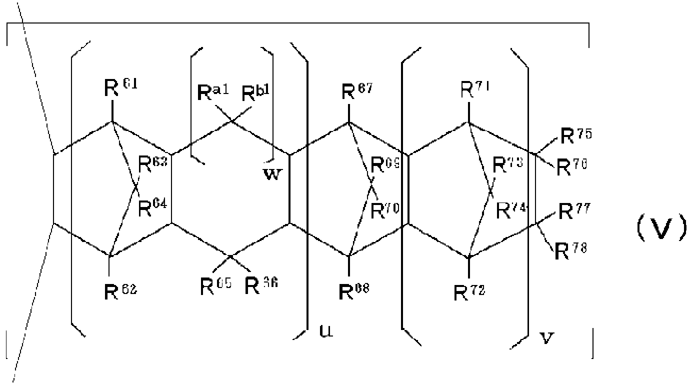
[in General Formula (V), u is 0 or 1, v is 0 or a positive integer, w is 0 or 1, R⁶¹ to R⁷⁸, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring], and
in a ¹³C-NMR spectrum of the cyclic olefin-based copolymer (m), in a case where an integral value of a signal in a range of equal to or more than 43.8 ppm and equal to or less than 45.0 ppm is represented by R_{B}, an integral value of a signal in a range of equal to or more than 40.3 ppm and equal to or less than 41.3 ppm is represented by M_{C}, and a total of integral values of signals in a range of equal to or more than 38.4 ppm and equal to or less than 39.9 ppm is represented by R_{B + C}, a value of (R_{B + C} - R_{B})/M_{C} is preferably equal to or more than 0.2 and equal to or less than 2.0.

The content of the cyclic olefin-based copolymer (m) in the varnish-like cyclic olefin-based copolymer composition is not particularly limited, but is preferably 30% by mass to 70% by mass, more preferably 30% by mass to 60% by mass, and still more preferably 30% by mass to 55% by mass. In a case where the content is within this range, the solution state of the varnish-like cyclic olefin-based copolymer composition can be further maintained.

### <Organic Solvent>

A solvent for preparing the varnish-like cyclic olefin-based copolymer composition is not particularly limited as long as it does not impair the solubility or the affinity with respect to the cyclic olefin-based copolymer (m).

The organic solvent preferably includes at least one selected from the group consisting of an aromatic hydrocarbon-based solvent, a cyclic hydrocarbon-based solvent, a linear hydrocarbon-based solvent, and a halogenated aromatic hydrocarbon solvent, more preferably includes at least one selected from the group consisting of the aromatic hydrocarbon-based solvent such as toluene, benzene, xylene, mesitylene, and pseudocumene; a cyclic hydrocarbon-based solvent such as cyclohexane, methylcyclohexane, and decahydronaphthalene; a linear hydrocarbon-based solvent such as heptane, hexane, octane, and decane; and a halogenated hydrocarbon solvent such as trichloroethylene, dichloroethylene, and chlorobenzene, still more preferably includes at least one selected from the group consisting of the aromatic hydrocarbon-based solvent and the cyclic hydrocarbon-based solvent, even still more preferably includes at least one selected from the group consisting of toluene and cyclohexane, and even still further preferably includes toluene. These solvents can be alone or as a mixture of two or more kinds at any proportion.

The method for producing a varnish-like cyclic olefin-based copolymer composition of the present embodiment may include other steps such as a precipitation step of precipitating the obtained polymer.

### <Crosslinked Body (Q)>

The crosslinked body (Q) according to the present embodiment is obtained by crosslinking the cyclic olefin copolymer (m) according to the present embodiment or the cyclic olefin-based copolymer composition according to the present embodiment. The method for crosslinking the cyclic olefin copolymer (m) according to the present embodiment or the cyclic olefin-based copolymer composition according to the present embodiment is not particularly limited, and examples thereof include a method for performing crosslinking while or after performing molding into any shape, using a radical polymerization initiator, sulfur, a hydrosilyl group-containing compound, electron beams, or other radiation.

In a case of performing crosslinking with a radical polymerization initiator, it is possible to directly apply a crosslinking method using a normal radical polymerization initiator applied using a polyolefin. That is, a radical polymerization initiator such as dicumyl peroxide is blended into the cyclic olefin copolymer (m) or the cyclic olefin-based copolymer composition, heated, and subjected to crosslinking. The blending proportion of the radical polymerization initiator is not particularly limited, but is usually 0.02 to 20 parts by mass per 100 parts by mass of the cyclic olefin copolymer (m), preferably 0.05 to 10 parts by mass, and still more preferably 0.5 to 10 parts by mass. In a case where the blending proportion of the radical polymerization initiator is equal to or less than the upper limit value, it is possible to improve the dielectric characteristics of the crosslinked body (Q), and in a case where the content is equal to or more than the lower limit value, it is possible to improve the heat resistance and the mechanical characteristics of the crosslinked body (Q).

As the radical polymerization initiator, a known thermal radical polymerization initiator, a photoradical polymerization initiator, or a combination thereof can be used. Among these radical polymerization initiators, in a case where the thermal radical polymerization initiator is used, the 10-hour half-life temperature is usually equal to or higher than 80°C, and preferably equal to or higher than 120°C from the viewpoint of the storage stability. Examples of such initiators include dialkyl peroxides such as dicumyl peroxide, t-butyl cumyl peroxide, 2,5-bis(t-butylperoxy) 2,5-dimethylhexane, 2,5-bis(t-butylperoxy) 2,5-dimethyl hexyne-3, di-t-butyl peroxide, isopropyl cumyl-t-butyl peroxide, and bis(α-t-butylperoxy isopropyl)benzene; peroxy ketals such as 1,1-bis(t-butylperoxy) cyclohexane, 1,1-bis(t-butylperoxy) 3,3,5-trimethylcyclohexane, 1,1-bis(t-butylperoxy) cyclododecane, n-butyl-4,4-bis(t-butylperoxy) valerate, ethyl 3,3-bis(t-butylperoxy) butyrate, 3,3,6,6,9,9-hexamethyl-1,2,4,5-tetraoxycyclononane; peroxy esters such as bis(t-butylperoxy) isophthalate, t-butylperoxybenzoate, and t-butylperoxyacetate; hydroperoxides such as t-butyl hydroperoxide, t-hexyl hydroperoxide, cumin hydroperoxide, 1,1,3,3-tetramethylbutyl hydroperoxide, diisopropylbenzene hydroperoxide, and p-menthane hydroperoxide; bibenzyl compounds such as 2,3-dimethyl-2,3-diphenylbutane; and 3,3,5,7,7-pentamethyl-1,2,4-trioxepane.

Specific examples of the photoradical polymerization initiator among the radical polymerization initiators include benzoin alkyl ether, benzyl dimethyl ketal, 1-hydroxycyclohexyl phenyl ketone, 2-hydroxy-2-methyl-1-phenylpropan-1-one, benzophenone, methyl benzoyl formate, isopropyl thioxantone, and a mixture of two or more kinds thereof. In addition, a sensitizer can also be used together with the photoradical polymerization initiator. Examples of the sensitizer include carbonyl compounds such as anthraquinone, 1,2-naphthoquinone, 1,4-naphthoquinone, benzanthrone, p,p'-tetramethyldiaminobenzophenone, and chloranil, nitro compounds such as nitrobenzene, p-dinitrobenzene, and 2-nitrofluorene, aromatic hydrocarbons such as anthracene and chrysene, sulfur compounds such as diphenyldisulfide, and nitrogen compounds such as nitroaniline, 2-chloro-4-nitroaniline, 5-nitro-2-aminotoluene, and tetracyanoethylene.

In a case of crosslinking with sulfur or the like, the cyclic olefin-based copolymer composition is blended with a sulfur-based compound, and, as necessary, a vulcanization accelerator and a vulcanization acceleration aid, and heated to perform a crosslinking reaction. The blending amount of the sulfur-based compound is not particularly limited, but in terms of efficiently advancing the crosslinking reaction, improving the physical properties of the obtained crosslinked body, cost-effectiveness, and the like, the sulfur-based compound is usually used in the blending amount in a range of 0.1 to 10 parts by mass with respect to 100 parts by mass of the cyclic olefin copolymer (m), and preferably used in the blending amount in a range of 0.3 to 5 parts by mass. In a case of being used in combination with a vulcanization accelerator or a vulcanization acceleration aid, it is usually used in the blending amount in a range of 0.1 to 20 parts by mass, and preferably 0.2 to 10 parts by mass.

Various known sulfur-based compounds can be used to cause the crosslinking reaction, and examples thereof include sulfur, sulfur monochloride, sulfur dichloride, morpholine disulfide, alkylphenol disulfide, tetramethylthiuram disulfide, and selenium dimethyldithiocarbamate. In addition, various vulcanization accelerators can also be used, and examples thereof include thiazole-based vulcanization accelerators such as N-cyclohexyl-2-benzothiazole-sulfenamide, N-oxydiethylene-2-benzothiazole-sulfenamide, N,N-diisopropyl-2-benzothiazole sulfenamide, 2-mercaptobenzothiazole, 2-(2,4-dinitrophenyl)mercaptobenzothiazole, 2-(2,6-diethyl-4-morpholinothio)benzothiazole, and benzothiazyl-disulfide; guanidine-based vulcanization accelerators such as diphenyl guanidine, triphenyl guanidine, di-ortho-tolyl guanidine, ortho-tolyl biguanide, and diphenyl guanidine phthalate; an acetoldehyde-aniline reaction product; a butyraldehyde-aniline condensate; an aldehyde amine- or aldehyde ammonia-based vulcanization accelerators such as hexamethylenetetramine and acetoaldehyde ammonia; imidazoline-based vulcanization accelerators such as 2-mercaptoimidazoline; thiourea-based vulcanization accelerators such as thiocarbanilide, diethyl thiourea dibutyl thiourea, trimethyl thiourea, and diortho-tolyl thiourea; thiuram-based vulcanization accelerators such as tetramethyl thiuram monosulfide, tetramethylthiuram disulfide, tetraethylthiuram disulfide, tetrabutylthiuram disulfide, and dipentamethylenethiuram tetrasulfide; dithio acid salt-based vulcanization accelerators such as zinc dimethyldithiocarbamate, zinc diethylthiocarbamate, zinc di-n-butyldithiocarbamate, zinc ethylphenyldithiocarbamate, zinc butylphenyldithiocarbamate, sodium dimethyldithiocarbamate, selenium dimethyldithiocarbamate, and tellurium diethyldithiocarbamate; and xanthate-based vulcanization accelerators such as zinc dibutyl xanthate. Examples of the vulcanization acceleration aid include metal oxide-based vulcanization acceleration aids such as zinc oxide, activated zinc oxide, zinc carbonate, complex zinc oxide, magnesium oxide, litharge, red lead, and basic lead carbonate, fatty acid-based vulcanization acceleration aids such as stearic acid, oleic acid, lauric acid, and lead stearate, and organic amine glycol-based vulcanization acceleration aids such as triethanol amine, and diethylene glycol.

A temperature at which the cyclic olefin copolymer (m) or the cyclic olefin-based copolymer composition is crosslinked with the radical polymerization initiator or sulfur is usually 100°C to 300°C, preferably 120°C to 250°C, and more preferably 120°C to 220°C, and the temperature may be changed in a stepwise manner to perform the crosslinking. In a case where the temperature is equal to or more than the lower limit value, it is possible to make the crosslinking proceed sufficiently. In addition, in a case where the temperature is equal to or less than the upper limit value, it is possible to suppress the coloration of the obtained crosslinked body and to simplify the process. Furthermore, as a reference, it is generally not possible for polybutadiene, which is a typical double bond-containing polymer, to be crosslinked under the conditions as described above, and crosslinking conditions at a high temperature such as 300°C are required.

The cyclic olefin copolymer (m) or the cyclic olefin-based copolymer composition according to the present embodiment can also be crosslinked using a hydrosilyl group-containing compound having at least two hydrosilyl groups in one molecule. It is possible to perform the crosslinking using the hydrosilyl group-containing compound according to, for example, the method described in Japanese Unexamined Patent Publication No. 2015-193680. The details thereof will not be repeated here.

Methods for performing the crosslinking using electron beams or other radiations have an advantage in that the temperature and the fluidity at the time of molding are not limited, and examples of the radiations include γ rays, and UV, in addition to electron beams.

In either case of the method using a radical polymerization initiator, sulfur, a hydrosilyl group-containing compound, or the like, or the method for performing the crosslinking using a radiation, it is possible to perform the crosslinking in combination with a crosslinking aid.

The crosslinking aid is not particularly limited, and examples thereof include oximes such as p-quinonedioxime and p,p'-dibenzoylquinonedioxime; acrylates or methacrylates such as ethylene dimethacrylate, polyethylene glycol dimethacrylate, trimethylolpropane trimethacrylate, cyclohexyl methacrylate, acrylic acid/zinc oxide mixture, and allyl methacrylate; vinyl monomers such as divinylbenzene, vinyltoluene, and vinylpyridine; allyl compounds such as hexamethylene diallyl nadimide, diallyl itaconate, diallyl phthalate, diallyl isophthalate, diallyl monoglycidyl isocyanurate, triallyl cyanurate, and triallyl isocyanurate; maleimide compounds such as N,N'-m-phenylene bismaleimide and N,N'-(4,4'-methylene diphenylene)dimaleimide; and cyclic non-conjugated dienes such as vinyl norbornene, ethylidene norbornene, and dicyclopentadiene. These crosslinking aids may be used alone or can be used in combination thereof.

It is possible to blend the crosslinked body (Q) according to the present embodiment with a heat resistant stabilizer, a weather stabilizer, an anti-static agent, a slip agent, an antiblocking agent, an anti-fogging agent, a lubricant, a dye, a pigment, a natural oil, a synthetic oil, a wax, an organic or inorganic filler, and the like, as necessary, to an extent where the purpose of the present invention is not impaired, and a blending proportion thereof is an appropriate amount. Specific examples of the stabilizer blended as an optional component include phenol-based antioxidants such as tetrakis[methylene-3(3,5-di-t-butyl-4-hydroxyphenyl)propionate]methane, β-(3,5-dit-butyl-4-hydroxyphenyl)propionic acid alkyl ester, and 2,2'-oxamidebis[ethyl-3(3,5-di-t-butyl-4-hydroxyphenyl)propionate]; fatty acid metal salts such as zinc stearate, calcium stearate, and calcium 12-hydroxystearate; and polyhydric alcohol fatty acid esters such as glycerin monostearate, glycerin monolaurate, glycerin distearate, pentaerythritol monostearate, pentaerythritol distearate, and pentaerythritol tristearate. These may be blended alone or in a combination thereof, and examples of the combination include a combination of tetrakis[methylene-3(3,5-di-t-butyl-4-hydroxyphenyl)propionate]methane with zinc stearate and glycerin monostearate.

Examples of the organic or inorganic filler include silica, silica earth, alumina, titanium oxide, magnesium oxide, pumice powder, pumice balloon, aluminum hydroxide, magnesium hydroxide, basic magnesium carbonate, dolomite, calcium sulfate, potassium titanate, barium sulfate, calcium sulfite, talc, clay, mica, asbestos, glass fibers, glass flakes, glass beads, calcium silicate, montmorillonite, bentonite, graphite, aluminum powder, molybdenum sulfide, boron fibers, silicon carbide fibers, polyethylene fibers, polypropylene fibers, polyester fibers, and polyamide fibers.

In order to mix the crosslinked body (Q) with various additives, a method in which the cyclic olefin copolymer (m) and various additives are melt-blended using an extruder or the like, or a solution blending method in which the cyclic olefin copolymer (m) and various additives are dissolved and dispersed in a suitable solvent, for example, a saturated hydrocarbon such as heptane, hexane, decane, and cyclohexane; or an aromatic hydrocarbon such as toluene, benzene, and xylene can be adopted.

The crosslinking reaction can also be performed on a mixture of the cyclic olefin-based copolymer composition, the above-described radical polymerization initiator or sulfur, and a compound such as a hydrosilyl group-containing compound in a molten state, the crosslinking reaction can also be performed on the mixture in a solution state of being dissolved or dispersed in a solvent, or the crosslinking reaction can also be allowed to further proceed after volatilizing a solvent from a solution state where the mixture is dissolved in the solvent and molding the residue into any shape such as a film and a coating.

In a case where the reaction is performed in the molten state, a raw material mixture is melt-kneaded using a kneading device such as a mixing roll, a Banbury mixer, an extruder, a kneader, and a continuous mixer, and reacted. In addition, the crosslinking reaction can also be allowed to proceed after performing the molding by any method.

As a solvent to be used for performing the reaction in the solution state, the same solvent as the solvent used in the solution blending method can be used.

In a case where the crosslinking reaction is performed using electron beams, the other radiation, or **UV,** the reaction can be performed after shaping by any method.

### <Molded Body>

The molded body according to the present embodiment includes the crosslinked body (Q) according to the present embodiment.

The molded body according to the present embodiment **is,** for example, a film or sheet.

Various known methods can be applied as a method for forming a film or sheet using the cyclic olefin copolymer (m) according to the present embodiment or the cyclic olefin-based copolymer composition according to the present embodiment. Examples of the method include a method in which the above-described varnish is applied onto a support base material such as a thermoplastic resin film to be dried, and then subjected to a heat treatment and the like to crosslink the cyclic olefin copolymer (m) according to the present embodiment or the cyclic olefin-based copolymer composition according to the present embodiment, thereby forming a film or sheet. A method for applying the varnish onto the support base material is not particularly limited, and examples thereof include coating using a spin coater, coating using a spray coater, and coating using a bar coater.

In addition, examples of the method also include a method in which the cyclic olefin copolymer (m) according to the present embodiment or the cyclic olefin-based copolymer composition according to the present embodiment is melt-molded to obtain a film or sheet.

The film or sheet of the present embodiment can be used as a laminate for various purposes by being laminated over a base material. As a method for forming the laminate of the present embodiment, various known methods can be applied.

The laminate can be manufactured by, for example, laminating a film or sheet produced by the above-described method over a base material, and performing heating and curing by pressing and the like, as necessary.

In addition, the laminate can also be manufactured by laminating an electrically insulating layer including the above-described crosslinked body over a conductor layer.

The cyclic olefin copolymer (m) according to the present embodiment or the cyclic olefin-based copolymer composition according to the present embodiment may be formed over surface layers of various multi-layer molded bodies or multi-layer laminated films. In this case, a resin layer formed from the cyclic olefin copolymer (m) according to the present embodiment or the cyclic olefin-based copolymer composition according to the present embodiment is preferably equal to or less than 100 µm.

Examples of the various multi-layer molded bodies or multi-layer laminated films include a multi-layer molded body for an optical lens, in which the cyclic olefin copolymer (m) according to the present embodiment or the cyclic olefin-based copolymer composition according to the present embodiment is formed over a surface of a resin optical lens, a multi-layer gas barrier film in which the cyclic olefin copolymer (m) according to the present embodiment or the cyclic olefin-based copolymer composition according to the present embodiment is formed over a surface of a resin film such as a PET film and a PE film in order to impart gas barrier properties.

In addition, the prepreg of the present embodiment is formed by combining the cyclic olefin copolymer (m) according to the present embodiment or the cyclic olefin-based copolymer composition according to the present embodiment and a sheet-like fiber base material.

A method for producing the prepreg is not particularly limited, various known methods can be used. Examples of the method include a method including a step of impregnating the above-described varnish into a sheet-like fiber base material to obtain an impregnated body, and a step of heating the obtained impregnated body and drying the solvent included in the varnish.

The impregnation of the varnish into the sheet-like fiber base material can be performed by, for example, applying a predetermined amount of the varnish onto the sheet-like fiber base material by a known method such as spray coating, dip coating, roll coating, curtain coating, die coating, and slit coating, overlaying a protective film thereon as necessary, and performing pressing with a roller and the like thereon from the upper side.

In addition, the step of heating the impregnated body and drying the solvent included in the varnish is not particularly limited, and examples thereof include a method such as batch-type drying in air or nitrogen with a blower dryer, or drying by heating in a heating furnace in a continuous step.

In the present embodiment, the prepreg can be obtained by impregnating the varnish into the sheet-like fiber base material, and then heating an impregnated body thus obtained to a predetermined temperature to evaporate the solvent included in the varnish.

As fibers constituting the sheet-like fiber base material according to the present embodiment, inorganic and/or organic fibers can be used and the fibers are not particularly limited. Examples of the fibers include organic fibers such as polyethylene terephthalate (PET) fibers, aramid fibers, ultrahigh molecular polyethylene fibers, polyamide (nylon) fibers, and liquid crystal polyester fibers; and inorganic fibers such as glass fibers, carbon fibers, alumina fibers, tungsten fibers, molybdenum fibers, titanium fibers, steel fibers, boron fibers, silicon carbide fibers, and silica fibers. Among these, the organic fibers or the glass fibers are preferable, and the aramid fibers, the liquid crystal polyester fibers, or the glass fibers are more preferable. Examples of the glass fibers include E glass, NE glass, S glass, D glass, H glass, and T glass.

The impregnation of the varnish into the sheet-like fiber base material is carried out by, for example, immersion and coating. The impregnation may be repeated a plurality of times, as necessary.

These sheet-like fiber base materials may be used each independently or in combination of two or more kinds thereof. The amount of the sheet-like fiber base material to be used is appropriately selected as desired, but is usually in a range of 10% to 90% by mass, preferably 20% to 80% by mass, and more preferably 30% to 70% by mass in a prepreg or laminate. Within these ranges, the dielectric characteristics and the mechanical strength of the obtained laminate are highly balanced, which is preferable.

A thickness of the prepreg according to the present embodiment is appropriately selected according to the purpose of use, but is usually 0.001 to 10 mm, preferably 0.005 to 1 mm, and more preferably 0.01 to 0.5 mm. Within these ranges, the shaping properties at the time of lamination and the characteristics such as mechanical strength and toughness of the laminate obtained by curing are sufficiently exhibited, which is suitable.

Since the cyclic olefin copolymer (m) according to the present embodiment or the cyclic olefin-based copolymer composition according to the present embodiment is excellent in dielectric characteristics, heat resistance, mechanical characteristics, and the like, it can be suitably used for a circuit board.

As a method for producing the circuit board, a generally known method can be used and the method is not particularly limited. Examples of the method include a film, a sheet, or a prepreg produced by the above-described method is heated and cured by a lamination press or the like to form an electrically insulating layer. Next, a conductor layer is laminated over the obtained electrically insulating layer by a known method to manufacture a laminate. Thereafter, the conductor layer in the laminate or the like can be subjected to circuit processing and the like to obtain a circuit board.

As a metal for the conductor layer, metals such as copper, aluminum, nickel, gold, silver, and stainless steel can be used. Examples of a method for forming the conductor layer include a method in which a metal is formed into a foil or the like, and thermally fused onto the electrically insulating layer, a method in which a metal is formed into a foil or the like and bonded to an electrically insulating layer using an adhesive, a method in which a conductor layer formed of the metals is formed over an electrically insulating layer by a method of sputtering, vapor deposition, plating, or the like. In an aspect of the circuit board, either a single-sided board or a double-sided board may be used.

Such a circuit board can be used as an electronic device by, for example, mounting an electronic part such as a semiconductor element thereon. The electronic device can be manufactured, based on known information.

Examples of such an electronic device include ICT infrastructure equipment such as a server, a router, a supercomputer, a mainframe, and a workstation; antennas such as a GPS antenna, antennas for a radio base station, a millimeter wave antenna, and an RFID antenna; communication devices such as a mobile phone, a smartphone, a PHS, a PDA, and a tablet terminal; digital devices such as a personal computer, a television, a digital camera, a digital video camera, a POS terminal, a wearable terminal, and a digital media player; vehicle-mounted electronic devices such as an electronic control system device, a vehicle-mounted communication device, a car navigation device, a millimeter wave radar, and an in-vehicle camera module; and semiconductor testing devices, high-frequency and measurement devices, and the like.

In addition, a foamed body can be obtained by crosslinking the cyclic olefin copolymer (m) according to the present embodiment or the cyclic olefin-based copolymer composition according to the present embodiment to be foamed. At this time, the above-described foaming agent may be added to the cyclic olefin-based copolymer composition.

### <Uses>

Since the crosslinked body (Q) according to the present embodiment is excellent in solvent resistance, heat resistance, mechanical strength, and transparency, a molded body formed of the crosslinked body (Q) can be used in uses as, for example, an optical fiber, an optical waveguide, an optical disc substrate, an optical filter, a lens, an optical adhesive, a PDP optical filter, a coating material for an organic EL, a base film base material for a solar cell in an aerospace field, a coating material for a solar cell and a thermal control system, a semiconductor element, a light emitting diode, electronic elements such as various types of memory, a hybrid IC, an MCM, a circuit board, a prepreg or laminate used for forming an insulating layer of a circuit board, overcoat materials or interlayer insulating materials for a display component or the like, a substrate for a liquid crystal display or a solar cell, medical instruments, automobile members, a mold releasing agent, a resin modifier, a transparent substrate for a display, members for a lithium-ion battery, semiconductor process members, a film capacitor, a gas barrier coating material, an electric wire coating material, automobile members, aerospace members, a process material for a semiconductor, a wire coating material, members for a lithium-ion battery, members for a fuel cell, a capacitor film, flexible display members, an anchor coat material, a transparent adhesive, a modified material, a crosslinking aid, a medical container, medical catheter members, a waterproof sealing material, a releasing material, a hard coat material, or a foam modifier.

In particular, since the crosslinked body (Q) is excellent in temporal stability of the dielectric characteristics, and is also excellent in solvent resistance, heat resistance, transparency, mechanical characteristics, and the like, it can be suitably used in high-frequency uses such as a high-frequency circuit board. Furthermore, since the crosslinked body (Q) is also excellent in gas barrier properties, it can be suitably used as a substrate for a liquid crystal display, a substrate of a solar cell, or a film or sheet.

The embodiments of the present invention have been described above, but these are examples of the present invention and various configurations other than the examples can also be adopted.

In addition, the present invention is not limited to the above-described embodiments, and modifications, improvements, and the like within ranges in which the object of the present invention can be achieved are included in the present invention.

### Examples

Hereinafter, the present invention will be described in more detail with reference to Synthesis Examples and Examples, but the present invention is not limited thereto in any way.

Furthermore, the compositions of the cyclic olefin-based copolymer (m) used in Synthesis Examples, Examples, and Comparative Examples were measured by the methods described below.

### [Method for Measuring Content of Each Structural Unit Constituting Cyclic Olefin-Based Copolymer]

Determination of the contents of the structural units (A), the structural units (B), and the structural units (C) was performed by measurement under the following conditions using a nuclear magnetic resonance device, "EXcalibur 270" manufactured by JEOL Ltd.
Integration times: 16 to 64 times
Measurement temperature: Room temperature

From the ¹H-NMR spectrum obtained in the measurement, each of the contents was calculated by the intensity of a signal derived from hydrogen directly bonded to the double-bonded carbon and the intensity of a signal of other hydrogen.

In addition, the number-average molecular weight (Mn) of the cyclic olefin-based copolymer (m) used in Synthesis Examples, Examples, and Comparative Examples was measured by GPC measurement and determined as a standard polystyrene-equivalent value. The GPC measurement was performed under the following conditions.
Device: GPC HLC-8321 (manufactured by Tosoh Corporation)
Solvent: o-Dichlorobenzene
Columns: TSKgel GMH6-HT × 2, TSKgel GMH6-HTL × 2 (both manufactured by Tosoh Corporation)
Flow rate: 1.0 ml/min
Sample: 1 mg/mL o-Dichlorobenzene solution
Temperature: 140°C

### [Glass Transition Temperature Tg (°C)]

By using DSC-6220 manufactured by Shimadzu Corporation, a glass transition temperature Tg of the cyclic olefin-based copolymer was measured in a nitrogen (N₂) atmosphere. The cyclic olefin-based copolymer was heated from room temperature to 200°C at a rate of temperature increase of 10°C/min and then held for 5 minutes, and then cooled to -20°C at a rate of temperature decrease of 10°C/min and then held for 5 minutes. Then, the glass transition point (Tg) of the cyclic olefin-based copolymer was determined from an endothermic curve in a case where the temperature was raised to 200°C at a rate of temperature increase of 10°C/min.

### [¹³C-NMR Measurement]

The ¹³C-NMR measurement was performed under the following conditions.
Device: AVANCE III cryo-500 type nuclear magnetic resonance manufactured by Bruker Biospin GmbH
Measurement nucleus: ¹³C (125 MHz)
Measurement mode: Single pulse proton (with reverse gate) decoupling
Pulse width: 90 Degrees
Number of points: 64,000
Measurement range: -55 to 195 ppm (total 250 ppm)
Repetition time: 12 seconds
Integration times: 256 times
Solvent: 1,1,2,2-Tetrachloroethane-d2
Concentration: 10% w/v
Temperature: 120°C
Chemical shift standard: Tetramethylsilane standard (corresponding to 1,1,2,2-tetrachloroethane-d2: 74.2 ppm)

The following raw materials were used for experiments.

Transition metal compound (1):
A transition metal compound (1) corresponding to the transition metal compound (A) was synthesized according to the method described in Macromolecules 2011, 44, 1986. 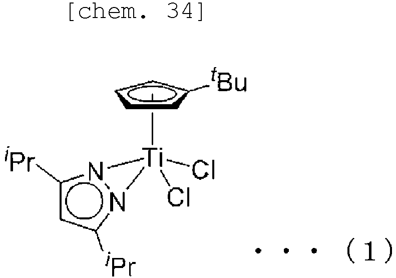 [In the formula, ^{t}Bu is a tert-butyl group and ⁱPr is an isopropyl group.]

Transition metal compound (2):
A transition metal compound (2) that does not correspond to the transition metal compound (A) was synthesized according to the method described in Japanese Unexamined Patent Publication No. 2004-331965.

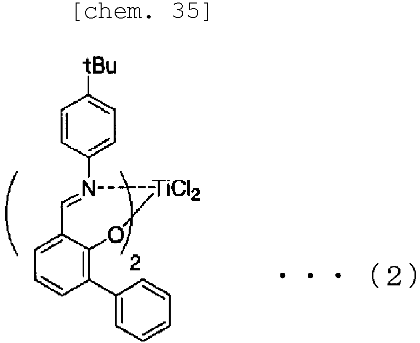

Transition metal compound (3):
A transition metal compound (3) that does not correspond to the transition metal compound (A) was synthesized according to the method described in J. Organomet. Chem., 1997, 527, 297 to 300.

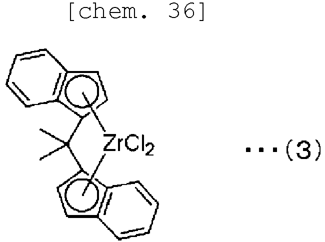

Ethylene (manufactured by Sumitomo Seika Chemicals Co., Ltd.)
Organic aluminum oxy compound (B-2): Modified methylaluminoxane (MMAO, manufactured by Tosoh Finechem Corporation)
Compound (B-3) that reacts with transition metal compound (A) to form ion pair: Triphenylcarbenium tetrakis(pentafluorophenyl)borate (manufactured by AGC Inc.)
Toluene (manufactured by Wako Pure Chemical Industries, Ltd.: Wako Special Grade)
5-Vinyl-2-norbornene (manufactured by Tokyo Chemical Industry Co., Ltd.)
2-Norbornene (manufactured by Tokyo Chemical Industry Co., Ltd.)
Acetone (manufactured by Wako Pure Chemical Industries, Ltd.: Wako Special Grade)
Methanol (manufactured by Wako Pure Chemical Industries, Ltd.: Wako Special Grade)

### Cyclic olefin-based copolymer (m):

### [Synthesis Example 1: Cyclic Olefin-Based Copolymer (m-1)]

339 mL of toluene, 65 ml of 5-vinyl-2-norbornene (hereinafter also referred to as VNB), 96 ml of tetracyclo [4.4.0.1^{2,5}.1^{7,10}]-3-dodecene (hereinafter also referred to as TD), 1.5 mmol of a hexane solution of MMAO, in terms of Al, and 93 ml of hydrogen were charged into an SUS autoclave having an internal volume of 1 L, which had been sufficiently substituted with nitrogen, and then ethylene was introduced into the system until the total pressure reached 0.75 MPa. 2.5 µmol of the transition metal compound (1) dissolved in toluene and 10 µmol of triphenylcarbenium tetrakis(pentafluorophenyl)borate dissolved in toluene were added thereto, and the mixture was reacted at 35°C for 30 minutes. Then, 2.5 µmol of the transition metal compound (1) and 10 µmol of triphenylcarbenium tetrakis(pentafluorophenyl)borate were further added thereto, and after 30 minutes, 2.5 µmol of the transition metal compound (1) and 10 µmol of triphenylcarbenium tetrakis(pentafluorophenyl)borate were further added to the mixture. Polymerization was performed for a total of 100 minutes, and then a small amount of methanol was added thereto to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/TD/VNB copolymer. The compositional ratio of the TD-derived structure and the compositional ratio of the VNB-derived structure in the polymer determined by NMR were 30% by mole and 16% by mole, respectively, and the number-average molecular weight (Mn) determined by GPC measurement was 21,000.

### [Synthesis Example 2: Cyclic Olefin-Based Copolymer (m-2)]

425 mL of toluene, 23 mL of VNB, 52 mL of a 5 M toluene solution of 2-norbornene (hereinafter also referred to as NB), 1.5 mmol of a hexane solution of MMAO, in terms of Al, and 124 mL of hydrogen were charged into a SUS autoclave having an internal volume of 1 L, which had been sufficiently substituted with nitrogen, and then ethylene was introduced into the system until the total pressure reached 0.75 MPa. 2.5 µmol of the transition metal compound (1) dissolved in toluene and 10 µmol of triphenylcarbenium tetrakis(pentafluorophenyl)borate dissolved in toluene were added thereto, and the mixture was reacted at 35°C for 30 minutes. Then, 2.5 µmol of the transition metal compound (1) and 10 µmol of triphenylcarbenium tetrakis(pentafluorophenyl)borate were further added thereto, and after 30 minutes, 2.5 µmol of the transition metal compound (1) and 10 µmol of triphenylcarbenium tetrakis(pentafluorophenyl)borate were further added to the mixture. Polymerization was performed for a total of 100 minutes, and then a small amount of methanol was added thereto to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/NB/VNB copolymer. The compositional ratio of the NB-derived structure and the compositional ratio of the VNB-derived structure in the polymer determined from NMR were 40% by mole and 10% by mole, respectively, and the number-average molecular weight (Mn) determined by GPC measurement was 8,000.

### [Synthesis Example 3: Cyclic Olefin-Based Copolymer (m-3)]

410 mL of toluene, 19 ml of VNB, 71 ml of TD, 1.5 mmol of a toluene solution of MMAO, in terms of Al, and 744 mL of hydrogen were charged into an SUS autoclave having an internal volume of 1 L, which had been sufficiently substituted with nitrogen, and then ethylene was introduced into the system until the total pressure reached 0.78 MPa. 40 µmol of the transition metal compound (2) dissolved in toluene was added thereto, the mixture was polymerized at 35°C for 180 minutes, and a small amount of methanol was added thereto to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/TD/VNB copolymer. The compositional ratio of the TD-derived structure and the compositional ratio of the VNB-derived structure in the polymer determined by NMR were 30% by mole and 12% by mole, respectively, and the number-average molecular weight (Mn) determined by GPC measurement was 11,000.

### [Synthesis Example 4: Cyclic Olefin-Based Copolymer (m-4)]

433 mL of toluene, 15 mL of VNB, 52 mL of a 5 M toluene solution of NB, 1.5 mmol of a hexane solution of MMAO, in terms of Al, and 1,488 mL of hydrogen were charged into an SUS-made autoclave having an internal volume of 1 L, which had been sufficiently substituted with nitrogen, and then ethylene was introduced into the system until the total pressure reached 0.78 MPaG. 4 µmol of the transition metal compound (2) dissolved in toluene was added thereto to initiate the polymerization. After performing the reaction at 35°C for 40 minutes, a step of adding 4 µmol of the transition metal compound (2) and further adding 4 µmol of the transition metal compound (2) every 30 minutes was repeated twice, and the polymerization was performed for a total of 130 minutes. Thereafter, a small amount of methanol was added to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/NB/VNB copolymer. The compositional ratio of the NB-derived structure and the compositional ratio of the VNB-derived structure in the polymer determined from NMR were 33% by mole and 10% by mole, respectively, and the number-average molecular weight (Mn) determined by GPC measurement was 7,500.

### [Synthesis Example 5: Cyclic Olefin-Based Copolymer (m-5)]

340 mL of toluene, 35 mL of VNB, 82 mL of a 5 M toluene solution of NB, 44 mL of TD, 2 mmol in terms of Al of a hexane solution of MMAO, and 558 mL of hydrogen were charged into an SUS-made autoclave having an internal volume of 1 L, which had been sufficiently substituted with nitrogen, and then ethylene was introduced into the system until the total pressure reached 0.52 MPaG. 4.7 µmol of the transition metal compound (2) dissolved in toluene was added thereto to initiate the polymerization. The mixture was reacted at 35°C for 40 minutes, 9.3 µmol of the transition metal compound (2) was added thereto, after 30 minutes, 9.3 µmol of the transition metal compound (2) was further added thereto, and then the mixture was reacted for 30 minutes to perform polymerization for a total of 100 minutes. Thereafter, a small amount of methanol was added to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/TD/NB/VNB copolymer. The compositional ratio of the TD-derived structure, the compositional ratio of the NB-derived structure, and the compositional ratio of the VNB-derived structure in the polymer determined by NMR were 14% by mole, 17% by mole, and 10% by mole, respectively, and the number-average molecular weight (Mn) determined by GPC measurement was 8,400.

### [Synthesis Example 6: Cyclic Olefin-Based Copolymer (m-6)]

378 mL of toluene, 79 ml of VNB, 43 ml of TD, 1.5 mmol of a toluene solution of MMAO, in terms of Al, and 744 mL of hydrogen were charged into an SUS autoclave having an internal volume of 1 L, which had been sufficiently substituted with nitrogen, and then ethylene was introduced into the system until the total pressure reached 0.78 MPa. 40 µmol of the transition metal compound (2) dissolved in toluene was added thereto, the mixture was polymerized at 35°C for 180 minutes, and a small amount of methanol was added thereto to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/TD/VNB copolymer. The compositional ratio of the TD-derived structure and the compositional ratio of the VNB-derived structure in the polymer determined by NMR were 13% by mole and 30% by mole, respectively, and the number-average molecular weight (Mn) determined by GPC measurement was 11,000.

### [Synthesis Example 7: Cyclic Olefin-Based Copolymer (m-7)]

225 mL of toluene, 65 ml of VNB, 180 ml of TD, 1.5 mmol of a toluene solution of triisobutylaluminum in terms of Al, and 93 ml of hydrogen were charged into an SUS autoclave having an internal volume of 1 L, which had been sufficiently substituted with nitrogen, and then ethylene was introduced into the system until the total pressure reached 0.75 MPa. 2.5 µmol of the transition metal compound (3) dissolved in toluene and 10 µmol of triphenylcarbenium tetrakis(pentafluorophenyl)borate dissolved in toluene were added thereto, and the mixture was reacted at 35°C for 30 minutes. Then, 2.5 µmol of the transition metal compound (1) and 10 µmol of triphenylcarbenium tetrakis(pentafluorophenyl)borate were further added thereto, and after 30 minutes, 2.5 µmol of the transition metal compound (1) and 10 µmol of triphenylcarbenium tetrakis(pentafluorophenyl)borate were further added to the mixture. Polymerization was performed for a total of 100 minutes, and then a small amount of methanol was added thereto to stop the polymerization. After the completion of the polymerization, ion exchange water was added to the obtained polymer solution, the mixture was stirred for 1 hour, and then the organic layer was filtered through filter paper to remove the catalyst. The organic layer was added to acetone to precipitate the polymer, which was stirred and filtered through filter paper. The obtained polymer was dried under reduced pressure at 80°C for 10 hours to obtain an ethylene/TD/VNB copolymer. The compositional ratio of the TD-derived structure and the compositional ratio of the VNB-derived structure in the polymer determined by NMR were 30% by mole and 10% by mole, respectively, and the number-average molecular weight (Mn) determined by GPC measurement was 9,000.

### [Examples 1 to 4 and Comparative Examples 1 to 5]

Each varnish was manufactured by the following method and evaluated.

### [Preparation of Varnish]

The cyclic olefin copolymer (m) was mixed with cyclohexane or toluene in the blending amount (the unit is part by mass) shown in Table 1, and the mixture was stirred overnight to obtain a varnish-like cyclic olefin-based copolymer resin composition.

### (Stereoregularity)

¹³C-NMR measurement was performed, and in a case where an integral value of a signal in a range of equal to or more than 43.8 ppm and equal to or less than 45.0 ppm was defined as X_{C}, an integral value of a signal in a range of equal to or more than 40.3 ppm and equal to or less than 41.3 ppm was defined as Y_{A}, and a total of integral values of signals in a range of equal to or more than 38.4 ppm and equal to or less than 39.9 ppm was defined as X_{B}, a value of (X_{B} - X_{C})/Y_{A} was calculated.

Here, the stability of the varnish was evaluated as follows.

The varnish in which there was no precipitate and gelation was not observed after standing for 2 weeks in an environment at a temperature of 22°C to 27°C and a humidity of 30% to 70% was evaluated as "A", the varnish in which there was no precipitate but gelation was observed after standing for 2 weeks in the environment was evaluated as "B", and the varnish in which there were undissolved residues at the time of stirring overnight or there was a precipitate after standing for 2 weeks in the environment was evaluated as "C".

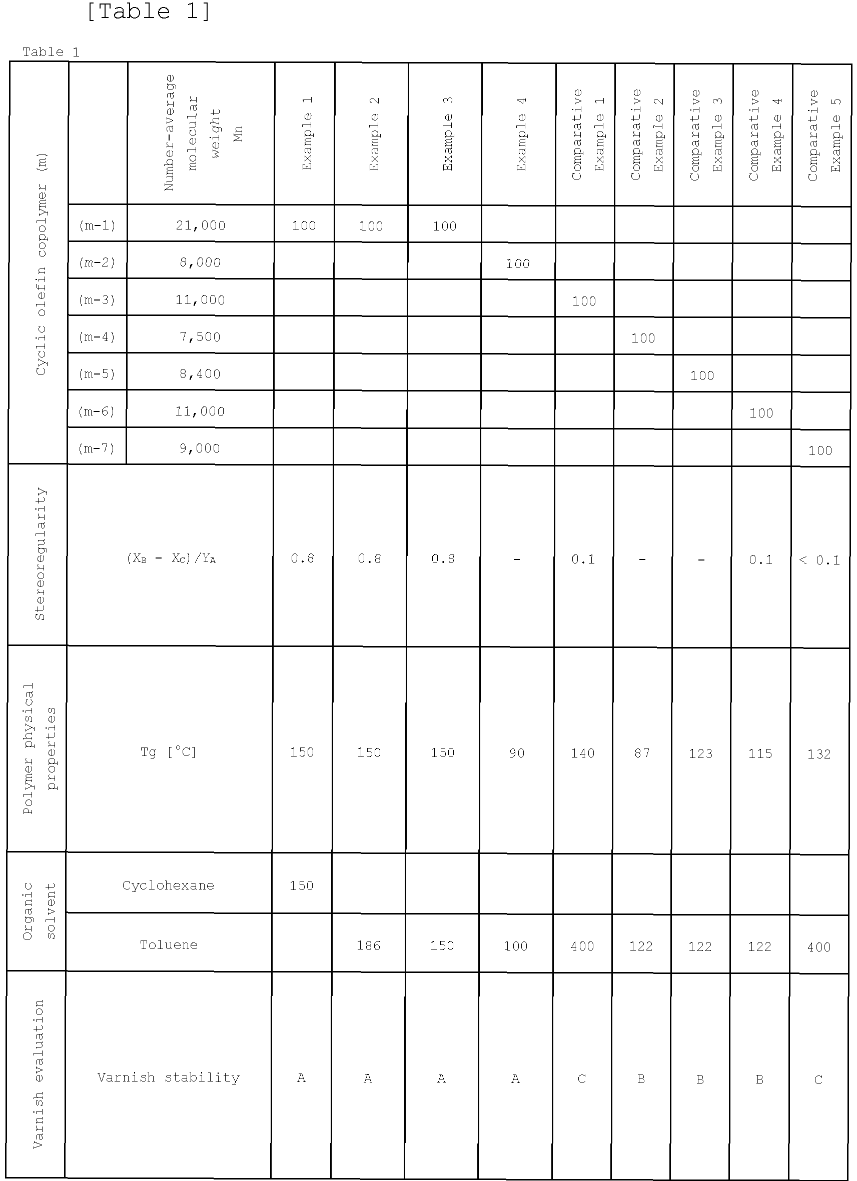

In Table 1, "-" in the column of "Stereoregularity" indicates that the value of (X_{B} - X_{C})/Y_{A} could not be measured.

This application claims priority based on Japanese Patent Application No. 2022-102901 filed on June 27, 2022, the disclosures of which are incorporated herein by reference in their entireties.

## Claims

1. A method for producing a varnish-like cyclic olefin-based copolymer composition including a cyclic olefin-based copolymer (m) and an organic solvent,
wherein the cyclic olefin-based copolymer (m) includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V), 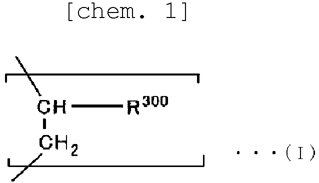
[in General Formula (I), R³⁰⁰ represents a hydrogen atom or a linear or branched hydrocarbon group having 1 to 29 carbon atoms] 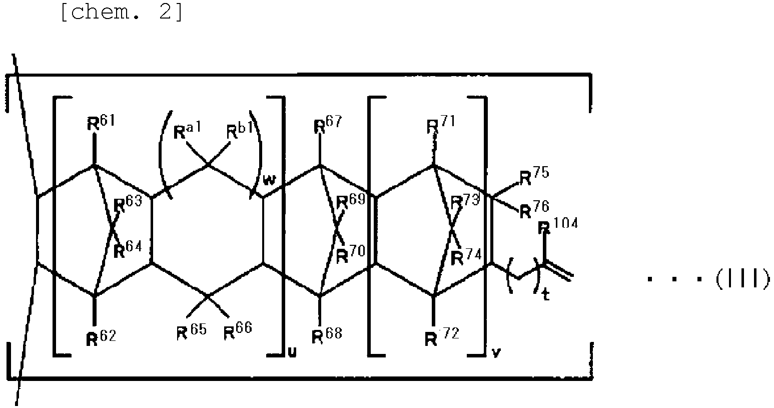
[in General Formula (III), u is 0 or 1, v is 0 or a positive integer, w is 0 or 1, R⁶¹ to R⁷⁶, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring] 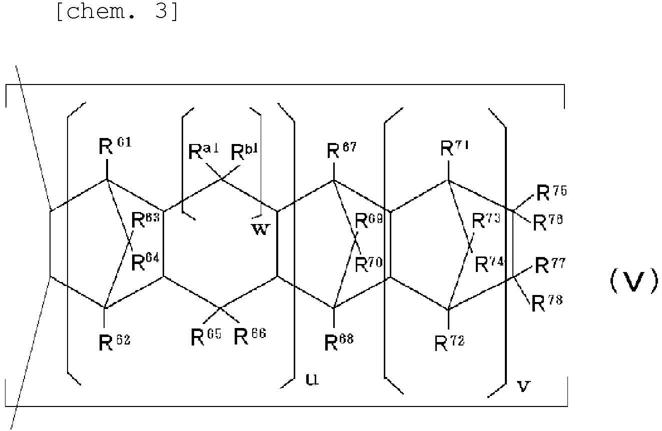
[in General Formula (V), u is 0 or 1, v is 0 or a positive integer, w is 0 or 1, R⁶¹ to R⁷⁸, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring],
the method includes a polymerization step of copolymerizing an olefin, a cyclic non-conjugated diene, and a cyclic olefin in a presence of a catalyst for olefin polymerization, containing a transition metal compound (A) and a compound (B), and the transition metal compound (A) contains one or two or more selected from the group consisting of a transition metal compound (A-1) represented by Formula (II) and a transition metal compound (A-2) represented by Formula (VI), 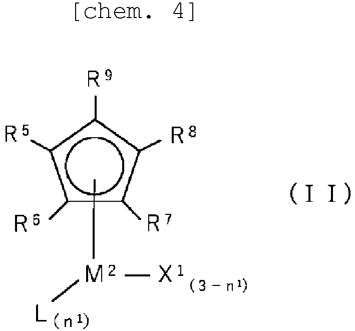
[in Formula (II), M² represents a transition metal atom of Group 4 of a periodic table, n¹ represents an integer of 1 to 3, L's each independently represent a monovalent anionic ligand in which an atom of Group 15 of the periodic table serves as a coordinating atom, X¹'s each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, R⁵ to R⁹ each independently represent a group or atom selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, any two or three of R⁵ to R⁹ may be fused to form a ring, and the ring to be formed may have aromaticity including a conjugated double bond] 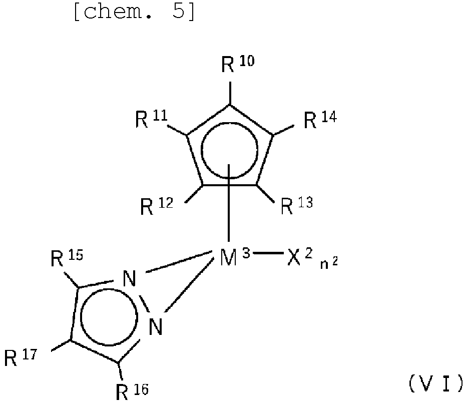
[in Formula (VI), M³ represents a transition metal atom of Group 4 of the periodic table, n² represents an integer of 1 to 4, X²'s each independently represent an atom or group selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, R¹⁰ to R¹⁷ each independently represent an atom or group selected from the group consisting of a hydrogen atom, a halogen atom, a hydrocarbon group, a halogen-containing group, an oxygen-containing group, a sulfur-containing group, a nitrogen-containing group, a phosphorus-containing group, a silicon-containing group, a boron-containing group, and an aluminum-containing group, as well as the group consisting of substitution products of these groups, adjacent groups of R¹⁰ to R¹⁷ may be bonded to each other to form a ring, and the ring to be formed may have aromaticity including a conjugated double bond], and
the compound (B) contains one or two or more selected from the group consisting of an organic metal compound (B-1), an organic aluminum oxy compound (B-2), and a compound (B-3) that reacts with the transition metal compound (A) to form an ion pair.

2. The production method according to Claim 1,
wherein a content of the cyclic olefin-based copolymer (m) in the varnish-like cyclic olefin-based copolymer composition is equal to or more than 30% by mass.

3. The production method according to Claim 1 or 2,
wherein the organic solvent includes at least one selected from the group consisting of an aromatic hydrocarbon-based solvent, a cyclic hydrocarbon-based solvent, a linear hydrocarbon-based solvent, and a halogenated aromatic hydrocarbon solvent.

4. The production method according to any one of Claims 1 to 3,
wherein in a case where a total number of moles of repeating units in the cyclic olefin-based copolymer (m) is set to 100% by mole, a content of the repeating units derived from the olefins (A) is equal to or more than 10% by mole and equal to or less than 90% by mole, a content of the repeating units derived from the cyclic non-conjugated dienes (B) is equal to or more than 1% by mole and equal to or less than 40% by mole, and a content of the repeating units derived from the cyclic olefins (C) is equal to or more than 1% by mole and equal to or less than 50% by mole.

5. The production method according to any one of Claims 1 to 4,
wherein the cyclic non-conjugated dienes constituting the repeating units derived from the cyclic non-conjugated dienes (B) include 5-vinyl-2-norbornene.

6. The production method according to any one of Claims 1 to 5,
wherein the cyclic olefins constituting the structural units derived from the cyclic olefins (C) include at least one selected from the group consisting of tetracyclo [4.4.0.1^{2,5}.1^{7,10}]-3-dodecene and bicyclo[2.2.1]-2-heptene.

7. The production method according to any one of Claims 1 to 6,
wherein the method further includes a catalyst removing step of removing the catalyst for olefin polymerization.

8. The production method according to any one of Claims 1 to 7,
wherein in a ¹³C-NMR spectrum of the cyclic olefin-based copolymer (m), in a case where an integral value of a signal in a range of equal to or more than 43.8 ppm and equal to or less than 45.0 ppm is defined as X_{C}, an integral value of a signal in a range of equal to or more than 40.3 ppm and equal to or less than 41.3 ppm is defined as Y_{A}, and an integral value of a signal in a range of equal to or more than 38.4 ppm and equal to or less than 39.9 ppm is defined as X_{B}, a value of (X_{B} - X_{C})/Y_{A} is equal to or more than 0.2 and equal to or less than 2.0.

9. The production method according to any one of Claims 1 to 8,
wherein a glass transition temperature of the cyclic olefin-based copolymer (m) measured by a differential scanning calorimeter (DSC) is equal to or higher than 100°C.

10. A cyclic olefin-based copolymer composition obtained by the production method according to any one of Claims 1 to 9.

11. A crosslinked body obtained by crosslinking the cyclic olefin-based copolymer composition according to Claim 10.

12. A film or sheet comprising:
the crosslinked body according to Claim 11.

13. A laminate obtained by laminating the film or sheet according to Claim 12 over a base material.

14. A circuit board comprising:
an electrically insulating layer including the crosslinked body according to Claim 11; and
a conductor layer provided over the electrically insulating layer.

15. An electronic device comprising:
the circuit board according to Claim 14.

16. A prepreg comprising:
the cyclic olefin-based copolymer composition according to Claim 10; and
a sheet-like fiber base material.

17. A varnish-like cyclic olefin-based copolymer composition comprising:
a cyclic olefin-based copolymer (m); and
an organic solvent,
wherein the cyclic olefin-based copolymer (m) includes (A) one or more repeating units derived from an olefin represented by General Formula (I), (B) one or more repeating units derived from a cyclic non-conjugated diene represented by General Formula (III), and (C) one or more repeating units derived from a cyclic olefin represented by General Formula (V), 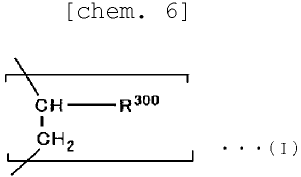
[in General Formula (I), R³⁰⁰ represents a hydrogen atom or a linear or branched hydrocarbon group having 1 to 29 carbon atoms] 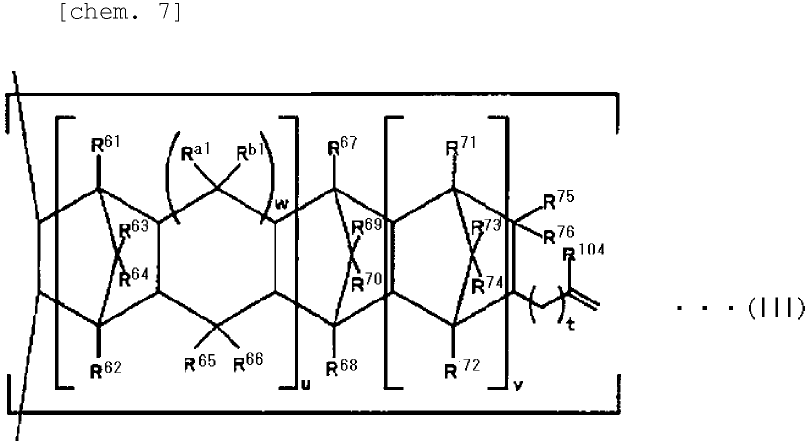
[in General Formula (III), u is 0 or 1, v is 0 or a positive integer, w is 0 or 1, R⁶¹ to R⁷⁶, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, R¹⁰⁴ is a hydrogen atom or an alkyl group having 1 to 10 carbon atoms, t is a positive integer of 0 to 10, and R⁷⁵ and R⁷⁶ may be bonded to each other to form a monocyclic ring or a polycyclic ring] 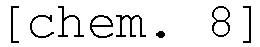 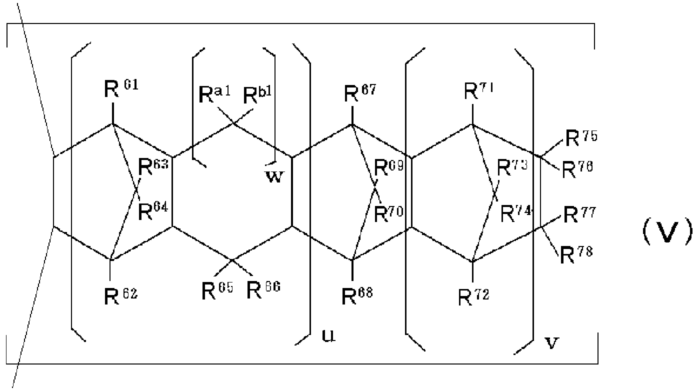
[in General Formula (V), u is 0 or 1, v is 0 or a positive integer, w is 0 or 1, R⁶¹ to R⁷⁸, R^{a1}, and R^{b1} may be the same as or different from each other, and are each a hydrogen atom, a halogen atom, an alkyl group having 1 to 20 carbon atoms, a halogenated alkyl group having 1 to 20 carbon atoms, a cycloalkyl group having 3 to 15 carbon atoms, or an aromatic hydrocarbon group having 6 to 20 carbon atoms, and R⁷⁵ to R⁷⁸ may be bonded to each other to form a monocyclic ring or a polycyclic ring], and
in a ¹³C-NMR spectrum of the cyclic olefin-based copolymer (m), in a case where an integral value of a signal in a range of equal to or more than 43.8 ppm and equal to or less than 45.0 ppm is defined as X_{C}, an integral value of a signal in a range of equal to or more than 40.3 ppm and equal to or less than 41.3 ppm is defined as Y_{A}, and a total of integral values of signals in a range of equal to or more than 38.4 ppm and equal to or less than 39.9 ppm is defined as X_{B}, a value of (X_{B} - X_{C})/Y_{A} is equal to or more than 0.2 and equal to or less than 2.0.

18. The varnish-like cyclic olefin-based copolymer composition according to Claim 16,
wherein a glass transition temperature of the cyclic olefin-based copolymer (m) measured by a differential scanning calorimeter (DSC) is equal to or higher than 100°C.

19. The varnish-like cyclic olefin-based copolymer composition according to Claim 17 or 18,
wherein a content of the cyclic olefin-based copolymer (m) in the varnish-like cyclic olefin-based copolymer composition is equal to or more than 30% by mass.

20. The varnish-like cyclic olefin-based copolymer composition according to any one of Claims 17 to 19,
wherein the organic solvent includes at least one selected from the group consisting of an aromatic hydrocarbon-based solvent, a cyclic hydrocarbon-based solvent, a linear hydrocarbon-based solvent, and a halogenated aromatic hydrocarbon solvent.

21. The varnish-like cyclic olefin-based copolymer composition according to any one of Claims 17 to 20,
wherein in a case where a total number of moles of repeating units in the cyclic olefin-based copolymer (m) is 100% by mole, a content of the repeating units derived from the olefins (A) is equal to or more than 10% by mole and equal to or less than 90% by mole, a content of the repeating units derived from the cyclic non-conjugated dienes (B) is equal to or more than 1% by mole and equal to or less than 40% by mole, and a content of the repeating units derived from the cyclic olefins (C) is equal to or more than 1% by mole and equal to or less than 50% by mole.

22. The varnish-like cyclic olefin-based copolymer composition according to any one of Claims 17 to 21,
wherein the cyclic non-conjugated dienes constituting the repeating units derived from the cyclic non-conjugated dienes (B) include 5-vinyl-2-norbornene.

23. The varnish-like cyclic olefin-based copolymer composition according to any one of Claims 17 to 22,
wherein the cyclic olefins constituting the structural units derived from the cyclic olefins (C) include at least one selected from the group consisting of tetracyclo[4.4.0. 1^{2,5}.1^{7,10}]-3-dodecene and bicyclo[2.2.1]-2-heptene.

24. The varnish-like cyclic olefin-based copolymer composition according to any one of Claims 17 to 23,
wherein the olefins constituting the repeating units derived from the olefins (A) include ethylene, the cyclic non-conjugated dienes constituting the repeating units derived from the cyclic non-conjugated dienes (B) include 5-vinyl-2-norbornene, and the cyclic olefins constituting the structural units derived from the cyclic olefins (C) include tetracyclo[4.4.0.1^{2,5}.1^{7,10}]-3-dodecene.

25. A crosslinked body obtained by crosslinking the varnish-like cyclic olefin-based copolymer composition according to any one of Claims 17 to 24.

26. A film or sheet comprising:
the crosslinked body according to Claim 25.

27. A laminate obtained by laminating the film or sheet according to Claim 26 over a base material.

28. A circuit board comprising:
an electrically insulating layer including the crosslinked body according to Claim 25; and
a conductor layer provided over the electrically insulating layer.

29. An electronic device comprising:
the circuit board according to Claim 28.

30. A prepreg comprising:
the varnish-like cyclic olefin-based copolymer composition according to any one of Claims 17 to 24; and
a sheet-like fiber base material.
